(19) Europäisches Patentamt
European Patent Office
Office européen des brevets

(11) EP 2 247 171 B1

(12) **EUROPEAN PATENT SPECIFICATION**

(45) Date of publication and mention of the grant of the patent:
**22.04.2015 Bulletin 2015/17**

(21) Application number: **08867811.5**

(22) Date of filing: **24.12.2008**

(51) Int Cl.:
***H05K 3/18*** (2006.01) ***B32B 15/08*** (2006.01)
*H05K 1/03* (2006.01)

(86) International application number:
**PCT/JP2008/073447**

(87) International publication number:
**WO 2009/084540 (09.07.2009 Gazette 2009/28)**

(54) **METAL-CLAD SUBSTRATE, AND METHOD FOR PRODUCTION THEREOF**

METALLAUSGEKLEIDETES SUBSTRAT UND VERFAHREN ZU SEINER HERSTELLUNG

SUBSTRAT DE PLACAGE MÉTALLIQUE ET PROCÉDÉ POUR LA PRODUCTION DE CELUI-CI

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **27.12.2007 JP 2007338036**

(43) Date of publication of application:
**03.11.2010 Bulletin 2010/44**

(73) Proprietor: **FUJIFILM Corporation**
**Tokyo 106-8620 (JP)**

(72) Inventor: **UEKI, Shiki**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**JP-A- 6 090 087**
**JP-A- 2003 158 373**
**JP-A- 2006 135 271**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 247 171 B1

## Description

TECHNICAL FIELD

The present invention relates to a metal-clad substrate, and a method for production thereof.

BACKGROUND ART

Metal wiring boards each having a wiring formed from a metal pattern on the surface of an insulative substrate have been widely used hitherto in electronic parts or semiconductor devices.

As an example of the method for producing such a metal pattern, there is known a method of forming a conductor pattern by forming an adhesive layer on the surface of a substrate, roughening the surface of this adhesive layer, subsequently carrying out an activation treatment using a catalytic core-containing treating liquid which contains, as a catalytic core, a complex formed from a noble metal ion and an amino-based complexing agent, while controlling the amount of application of the catalytic core, and then performing electroless plating on the adhesive layer (see, for example, Patent Document 1). In this method, it can be attempted to shorten the duration of the catalyst application step while maintaining the adhesiveness and insulating properties of the conductor pattern.

However, this method of forming a conductor pattern requires roughening of the adhesive layer, and thus there is a problem that the method involves a large number of steps. Furthermore, Rmax of the roughened adhesive layer is about 5 μm to 20 μm, and the anchor effect brought by this surface unevenness results in an enhancement of the adhesiveness to the conductor pattern. However, this surface unevenness causes a problem that when the conductor pattern is used as metal wiring, the high frequency properties are deteriorated; a problem that there is a demand for increases in the precision and density of the conductor pattern; and particularly, a problem that it is difficult to obtain a conductor pattern (metal pattern) having a line width of less than 20 μm.

In order to solve these problems, there has been proposed a method for forming a metal film (see, for example, Patent Document 1), the method including forming, on a smooth surface (unevenness of 500 nm or less), a resin layer in which a polymer having a functional group which is capable of interacting with an electroless plating catalyst or a precursor thereof, is directly chemically bound, applying an electroless plating catalyst or a precursor thereof onto the resin layer, and then carrying out electroless plating. According to this method, certain successful results can be obtained, from the viewpoint that the method being a method of obtaining a metal film having excellent adhesiveness to substrates having high smoothness.

However, in regard to the demand for metal patterns having high precision and high density in recent years for printed wiring boards and the like, further enhancement is desired for the adhesiveness to a substrate or a resin layer, of which the interface with a metal film has high smoothness. In addition, it is a current situation that examination is being conducted on a method of more simply and easily forming such a metal film having excellent adhesiveness.

Patent Document 1: Japanese Patent Application Laid-Open (JP-A) No. 8-316612
Patent Document 1: JP-A No. 2006-193780

JP 2006 135271 A describes a method that forms fine metal patterns on a support, wherein the surface of the support has preferably concaves and convexes ranging 500 nm or smaller in depth. This method consists of (a) a step for forming a polymerization initiating layer in which a polymer having, on a side chain thereof, a crosslinking group and a functional group having polymerization initiating capability is immobilized on a support by a crosslinking reaction, (b) a step of forming a patterned polymer area in which a polymer having a functional group interacting with an electroless plating catalyst or its precursor forms a chemical bond directly with the polymerization initiating layer, (c) a step for supplying the electroless plating catalyst or its precursor to the patterned polymer area and (d) a step for conducting electroless coating and forming a patterned metal film.

DISCLOSURE OF INVENTION

PROBLEM TO BE SOLVED BY THE INVENTION

The present invention was made in consideration of the defects of the related art as described above, and the invention is intended to achieve the following objects.

That is, it is an object of the invention to provide a metal-clad substrate which has a plating film having excellent adhesiveness to resin layers with high smoothness, and a method for producing a metal-clad substrate, which method is capable of achieving plating with ease and capable of obtaining a plating film having excellent adhesiveness to resin layers with high smoothness.

MEANS FOR SOLVING PROBLEM

The present inventors of the invention made a thorough investigation under such circumstances, and found that the object described above may be achieved by the invention as defined in the independent claims 1 and 5.

That is, a metal-clad substrate including, on a substrate, a resin layer containing a plating catalyst or a precursor thereof, which resin layer satisfies the following requirement 1, and a plating film formed inside and on top of the resin layer:

Requirement 1: the resin layer contains the plating catalyst or a precursor thereof within a portion extending from a surface to a depth of 25 nm of the resin layer, in an amount in the range of $3\times10^{-20}$ mol/nm$^3$ to $30\times10^{-20}$ mol/nm$^3$ in terms of a content of a metal element thereof.

- The resin layer is formed from a composition containing a compound having a functional group which is capable of forming interaction with the plating catalyst or a precursor thereof, and a polymerizable group.
- The compound having the functional group which is capable of forming interaction with the plating catalyst or a precursor thereof, and the polymerizable roup, is a copolymer which contains a unit represented by the following formula (1) and a unit represented by the following formula (2):

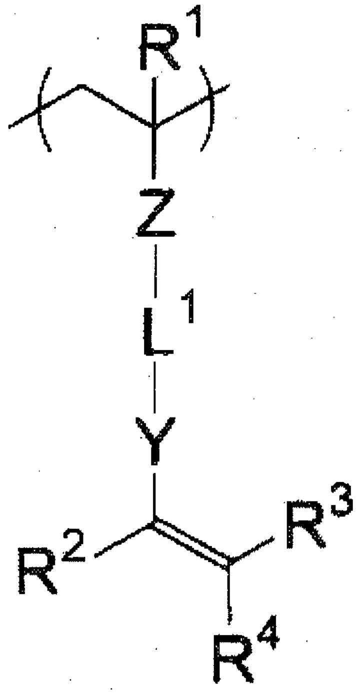

Formula (1)

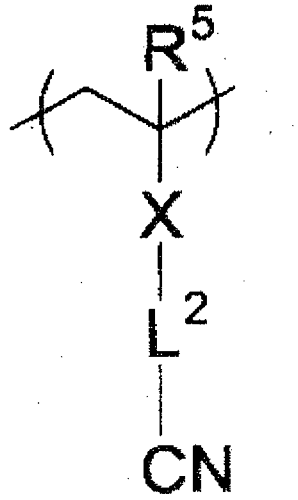

Formula (2)

In formula (1) and formula (2), $R^1$ to $R^5$ each independently represent a hydrogen atom, or a substituted or unsubstituted alkyl group; X, Y and Z each independently represent a single bond, a substituted divalent organic group, an unsubstituted divalent organic group, an ester group, an amide group, or an ether group; and $L^1$ and $L^2$ each independently represent a substituted or unsubstituted divalent organic group.

Furthermore, preferable aspects of the metal-clad substrate of the invention include the following.

- An aspect in which the arithmetic average roughness Ra, as defined in JIS B 0601 (2001), of the interface between the resin layer and the plating film, which appears when the metal-clad substrate is dissected along the normal line direction, is from 5 nm to 100 nm.
- An aspect of a metal-clad substrate in which an interface structure of a resin layer and a plating film, which appears when the metal-clad substrate is dissected along a normal line direction, is in a fractal form, and in which a fractal dimension of the interface structure calculated by applying the box count method, with a box size set at 50 nm to 5

µm and a pixel size set at 1/100 or less of the box size, is from 1.05 to 1.50.

- An aspect of the metal-clad substrate, wherein the metal element of the plating catalyst or a precursor thereof is selected from the group consisting of Pd, Ag, Cu, Cr, Pt, Rh, Sn and Ni.

A method for producing a metal-clad substrate, the method including:

(a) forming, on a substrate, a resin layer containing a plating catalyst or a precursor thereof, which resin layer satisfies the following requirement 1; and
(b) performing plating on the resin layer,

Requirement 1: the resin layer contains the plating catalyst or a precursor thereof within a portion extending from a surface to a depth of 25 nm of the resin layer, in an amount in the range of $3\times10^{-20}$ mol/nm$^3$ to $30\times10^{-20}$ mol/nm$^3$ in terms of a content of a metal element thereof.

- The resin layer is formed from a composition containing a compound having a functional group which is capable of forming interaction with the plating catalyst or a precursor thereof, and a polymerizable group.

- The compound having the functional group which is capable of forming interaction with the plating catalyst or a precursor thereof, and the polymerizable roup, is a copolymer which contains a unit represented by the following formula (1) and a unit represented by the following formula (2):

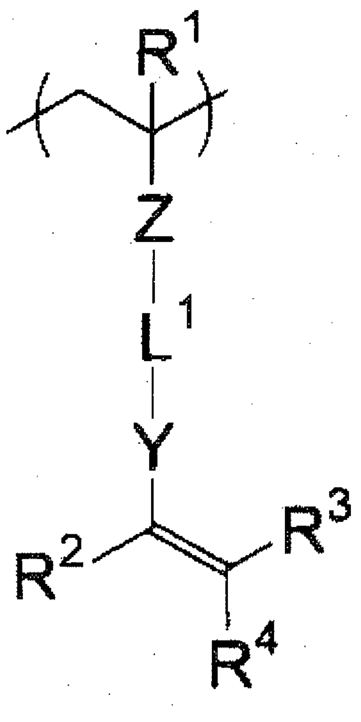

Formula (1)

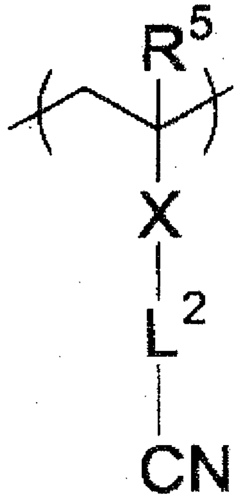

Formula (2)

In formula (1) and formula (2), $R^1$ to $R^5$ each independently represent a hydrogen atom, or a substituted or unsubstituted alkyl group; X, Y and Z each independently represent a single bond, a substituted divalent organic group, an unsubstituted divalent organic group, an ester group, an amide group, or an ether group; and $L^1$ and $L^2$ each independently represent a substituted or unsubstituted divalent organic group.

Preferred aspects of the method for producing a metal-clad substrate of the invention include the following.

- An aspect of forming a resin layer containing a plating catalyst or a precursor thereof, which resin layer satisfies the following requirement 2 in addition to the requirement 1, with regard to (a):

Requirement 2: the resin layer contains the plating catalyst or a precursor thereof within a portion extending

from a surface to a depth of 50 nm, in an amount in the range of $6\times10^{-20}$ mol/nm$^3$ to$60\times10^{-20}$ mol/nm$^3$ in terms of a content of a metal element thereof.

- An aspect of forming a resin layer containing a plating catalyst or a precursor thereof, which resin layer satisfies the following requirement 3 in addition to the requirements 1 and 2, with regard to (a):

  Requirement 3: the resin layer contains the plating catalyst or a precursor thereof within a portion extending from a surface to a depth of 100 nm, in an amount in the range of $12\times10^{-20}$ mol/nm$^3$ to$120\times10^{-20}$ mol/nm$^3$ in terms of a content of a metal element thereof.

- An aspect in which the resin layer formed in (a) contains a resin having a functional group which is capable of forming interaction with the plating catalyst or a precursor thereof.
- An aspect in which the functional group that is capable of forming interaction with the plating catalyst or a precursor thereof, contains a nitrogen atom.
- An aspect in which the functional group that is capable of forming interaction with the plating catalyst or a precursor thereof, includes a cyano group.
- An aspect of the metal element of the plating catalyst or a precursor thereof is selected from the group consisting of Pd, Ag, Cu, Cr, Pt, Rh, Sn and Ni.

EFFECT OF THE INVENTION

According to the present invention, there may be provided a metal-clad substrate which has a plating film having excellent adhesiveness to resin layers with high smoothness, and a method for producing a metal-clad substrate, which is capable of achieving plating with ease and capable of obtaining a plating film having excellent adhesiveness to resin layers with high smoothness.

BEST MODE FOR CARRYING OUT THE INVENTION

Hereinafter, the present invention will be explained in detail.

<Metal-clad substrate and method for production thereof>

The metal-clad substrate of the invention is characterized by having, on a substrate, a resin layer containing a plating catalyst or a precursor thereof, which resin layer satisfies the following requirement 1, and a plating film formed inside and on top of the resin layer.

Requirement 1 : the resin layer contains the plating catalyst or a precursor thereof within a portion extending from a surface to a depth of 25 nm of the resin layer, in an amount in the range of $3\times10^{-20}$ mol/nm$^3$ to $30\times10^{-20}$ mol/nm$^3$ in terms of a content of a metal element thereof.

Such a metal-clad substrate may be obtained by the method for producing a metal-clad substrate of the invention shown below.

The method for producing a metal-clad substrate of the invention is characterized by including (a) forming, on a substrate, a resin layer containing a plating catalyst or a precursor thereof, which resin layer satisfies the requirement 1 described above; and (b) performing plating on the resin layer.

Hereinafter, the respective steps of the method for producing a metal-clad substrate of the invention will be described in detail.

[Step (a)]

In the step (a), a resin layer containing a plating catalyst or a precursor thereof, which layer satisfies the following requirement 1, is formed on a substrate.

Requirement 1: the resin layer contains the plating catalyst or a precursor thereof within a portion extending from a surface to a depth of 25 nm of the resin layer, in an amount in the range of $3\times10^{-20}$ mol/nm$^3$ to $30\times10^{-20}$ mol/nm$^3$ in terms of a content of a metal element thereof.

When the requirement 1 is satisfied, the plating carried out in the step (b) that will be described later may be efficiently carried out, and extremely fine surface unevenness is formed on the surface of the resin layer so that the adhesiveness between the resin layer and the plating film formed in the step (b) may be enhanced.

Here, the extremely fine surface unevenness formed on a surface of the resin layer is such that the arithmetic average roughness Ra, as defined in JIS B 0601 (2001), is preferably from 5 nm to 100 nm, more preferably from 10

nm to 85 nm, and even more preferably from 15 nm to 60 nm. The standards of JIS B 0601 (2001) have been incorporated herein by reference.

According to the invention, it is preferable that the following requirement 2 be satisfied in addition to the above requirement 1, and it is more preferable that the following requirement 3 be satisfied in addition to the above requirement 1 and the following requirement 2.

Requirement 2: the resin layer contains the plating catalyst or a precursor thereof within a portion extending from a surface to a depth of 50 nm of the resin layer, in an amount in the range of $6\times10^{-20}$ mol/nm$^3$ to $60\times10^{-20}$ mol/nm$^3$ in terms of a content of a metal element thereof.

Requirement 3: the resin layer contains the plating catalyst or a precursor thereof within a portion extending from a surface to a depth of 100 nm of the resin layer, in an amount in the range of $12\times10^{-20}$ mol/nm$^3$ to $120\times10^{-20}$ mol/nm$^3$ in terms of a content of a metal element thereof.

When the requirements 2 and 3 are satisfied, it is made possible to control the surface roughness Ra of the interface between metal (plating film) and resin (resin layer) in the range of about 100 nm. When Ra is 5 nm or greater, sufficient adhesive power may be exhibited, and thus a higher Ra value leads to stronger adhesion. The metal-clad substrate of the invention makes it possible to make selection in accordance with the option of weighting the condition of sufficiently smoothness and minimal roughening (10 nm or less), or the option of weighting the condition of less roughening and strong adhesion, or the like, when the metal-clad substrate is applied as a printed board.

According to the invention, the following method is used as the method of measuring the contents of the plating catalyst and its precursor (amount of distribution of the plating and its precursor in the depth direction) in the resin layer.

That is, a sample (having a size of 50 mm on each side) having a formed resin layer is provided, and the content of the plating and its precursor in the resin layer is determined by RBS (Rutherford Backscattering Spectrometry). RBS is a method of irradiating the surface of a sample with $He^+$ ions having an energy of 2.0 MeV at an angle of 0° with respect to the normal line, and detecting the scattered $He^+$ ions at a position of a scattering angle of 160° using a semiconductor detector.

Furthermore, in order to avoid damages to the sample, the measurement was performed while the position of irradiation was shifted for every 1 μC, and the amount of distribution in the depth direction was determined by simulation fitting.

The method for forming a resin layer which satisfies the requirements as described above is not particularly limited, and the layer formation may be carried out by forming a resin layer from a resin chemically bound to the substrate by the means described below, and then applying a plating catalyst or a precursor thereof, or may be carried out by preparing a coating liquid containing a plating catalyst or a precursor thereof at a predetermined concentration and a resin, and applying and drying this coating liquid on the substrate.

That is, a resin layer formed from a resin chemically bound to the substrate is formed by, for example, using a general technique called surface graft polymerization. Graft polymerization is a method of synthesizing a graft (grafting) polymer by providing an active species on the chain of a polymer compound, and further polymerizing thereto another monomer which initiates polymerization with the active species. Particularly, when the polymer compound on which the active species is provided forms a solid surface, the method is referred to as surface graft polymerization.

Any known methods described in the literature may all be used as the surface graft polymerization method applied in the invention. For example, a photo-graft polymerization method and a plasma irradiation graft polymerization method are described as surface graft polymerization methods in page 135 of New Polymer Experimentology 10, edited by the Society of Polymer Science, Japan, and published in 1994 by Kyoritsu Shuppan co., Ltd. Furthermore, radiation irradiation graft polymerization methods using γ-rays, electron beams or the like are also described in pages 203 and 695 of Handbook of Adsorption Technology, published by NTS, Inc., under editorial supervision by Takeuchi in February 1999.

Specific methods of the photo-graft polymerization method that may be used include the methods described in JP-A Nos. 63-92658, 10-296895 and 11-119413.

The resin layer formed from a resin chemically bound to a substrate may also be formed by applying, in addition to the surface graft methods described above, a method of providing a reactive functional group such as a trialkoxysilyl group, an isocyanate group, an amino group, a hydroxyl group or a carboxyl group to a chain end of a polymer compound, and binding this reactive functional group with a functional group that is present on the substrate surface by a coupling reaction.

Among these methods, it is preferable to form a resin layer by using a photo-graft polymerization method, and more particularly, a photo-graft polymerization method making use of UV light, from the viewpoint of generating larger amounts of graft polymers.

[Substrate]

According to the invention, any substrate may be used without any particular limitation, as long as it has shape

retaining properties to an extent capable of forming a resin layer, and the substrate may be appropriately determined in accordance with the use of the metal-clad substrate to be produced.

In the case of forming a resin layer formed from a resin chemically bound to the substrate in the step (a), it is preferable that the surface of the substrate have a function capable of forming a state in which the resin is chemically bound thereto, or a substrate itself having such surface characteristics is also acceptable. Furthermore, a substrate in which a separate intermediate layer (for example, a polymerization initiating layer or adhesion aiding layer that will be described later) is provided so that the intermediate layer has such characteristics, may also be used.

(Substrate)

In the substrate used in the invention, for example, paper, paper laminated with a plastic (for example, polyethylene, polypropylene, polystyrene, or the like), a metal plate (for example, aluminum, zinc, copper, or the like), a plastic film (for example, cellulose diacetate, cellulose triacetate, cellulose propionate, cellulose butyrate, cellulose acetate, cellulose nitrate, polyethylene terephthalate, polyethylene, polystyrene, polypropylene, polycarbonate, polyvinylacetal, polyimide, an epoxy, a bismaleinimide resin, polyphenylene oxide, a liquid crystal polymer, polytetrafluoroethylene, or the like), paper or a plastic film having a metal such as mentioned above laminated or deposited thereon, and the like are preferably used. For the substrate used in the invention, an epoxy resin or a polyimide resin is preferred.

The substrate as described herein may also be used as a base material when an intermediate layer or a polymerization initiating layer is to be formed. If the substrate is constructed from a resin, the substrate may be constructed from the same material as that of the resin layer to be formed.

As the substrate according to the invention, the base material described in paragraphs [0028] to [0088] of JP-A No. 2005-281350, containing a polyimide having a polymerization initiation site in the skeleton, may also be used.

The metal-clad substrate of the invention may be applied to semiconductor packaging, various electric wiring boards and the like. When the metal-clad substrate is used for such purposes, it is preferable to use a substrate containing an insulating resin that will be described below, more specifically, a substrate formed from an insulating resin or a substrate having a layer formed from an insulating resin.

When a substrate formed from an insulating resin or a layer formed from an insulating resin is to be obtained, a known insulating resin composition is used. This insulating resin composition may contain various additives according to the purpose, in addition to a main resin. For example, measures may be taken, such as adding a polyfunctional acrylate monomer for the purpose of increasing the strength of the insulating layer, or adding inorganic or organic particles for the purpose of increasing the strength of the insulator layer and improving electrical properties.

Additionally, the "insulating layer" according to the invention means a resin having insulating properties to the extent that the resin can be used in a known insulating film or insulating layer. Thus, any resin that has insulating properties adequate for the purpose, even though it may not be a perfect insulator, may be applied in the invention.

Specifically, the insulating resin may be, for example, a thermosetting resin or a thermoplastic resin, or may be a mixture thereof. Examples of the thermosetting resin include an epoxy resin, a phenolic resin, a polyimide resin, a polyester resin, a bismaleimide resin, a polyolefin-based resin, an isocyanate-based resin and the like, and an epoxy resin and a polyimide resin are preferred.

Examples of the thermoplastic resin include a phenoxy resin, polyether sulfone, polysulfone, polyphenylene sulfone, polyphenylene sulfide, polyphenyl ether, polyether imide, and the like.

The thermoplastic resin and the thermosetting resin may be used singly, or may also be used in combination of two or more kinds. This is implemented for the purpose of exhibiting excellent effects by complementing the flaws of the respective resins.

The insulating resin composition may also contain a component such as a compound having a polymerizable double bond, specifically such as an acrylate or methacrylate compound, in order to proceed crosslinking, and in particular, a polyfunctional compound is preferred. In addition to those, a resin obtained by partially (meth)acrylating a thermosetting resin or a thermoplastic resin such as, for example, an epoxy resin, a phenolic resin, a polyimide resin, a polyolefin resin or a fluororesin, using methacrylic acid, acrylic acid or the like, may also be used as the compound having a polymerizable double bond.

The insulating resin composition according to the invention may also use a composite (composite material) of a resin and another component, so as to strengthen the properties of the resin film, such as mechanical strength, heat resistance, weather resistance, flame retardancy, water resistance and electrical properties. Examples of the material used in producing a composite include paper, glass fiber, silica particles, a phenolic resin, a polyimide resin, a bismaleimide triazine resin, a fluororesin, a polyphenylene oxide resin, and the like.

Furthermore, this insulating resin composition may also be incorporated, as necessary, with one or two or more kinds of fillers used in general resin materials for wiring boards, for example, inorganic fillers such as silica, alumina, clay, talc, aluminum hydroxide and calcium carbonate, and organic fillers such as a cured epoxy resin, a crosslinked benzoguanamine resin and a crosslinked acrylic polymer. Among them, it is preferable to use silica as a filler material.

This insulating resin composition may also be added, as necessary, with one or two or more kinds of various additives such as a colorant, a flame retardant, a tackifying agent, a silane coupling agent, an oxidation inhibitor, and an ultraviolet absorbent.

When these materials are added to the insulating resin composition, the materials are all added preferably in an amount in the range of 1 to 200% by mass, and more preferably in the range of 10 to 80% by mass, based on the resin. If this amount of addition is less than 1% by mass, the effect of strengthening the above-mentioned properties is absent, and if the amount of addition is greater than 200% by mass, the properties inherent to the resin, such as strength, are deteriorated.

Specifically, the substrate that may be used for such purposes is preferably a substrate formed from an insulating resin having a dielectric constant (relative permittivity) at 1 GHz of 3.5 or less, or a substrate having a layer formed from the relevant insulating resin. The substrate is also preferably a substrate formed from an insulating resin having a dielectric tangent at 1 GHz of 0.01 or less, or a substrate having a layer formed from the relevant insulating resin.

The dielectric constant and dielectric tangent of an insulating resin may be measured by conventional methods. For example, they may be measured according to the methods described in page 189 of "Proceedings for the 18th Symposium of Japan Institute of Electronics Packaging," 2004, using a cavity resonator perturbation method (for example, an instrument for measuring εr and tanδ for very thin sheets, manufactured by Keycom Corp.).

As such, it is also useful in the invention to select an insulating resin material from the viewpoint of the dielectric constant or dielectric tangent. Examples of an insulating resin having a dielectric constant of 3.5 or less and a dielectric tangent of 0.01 or less include a liquid crystal polymer, a polyimide resin, a fluororesin, a polyphenylene ether resin, a cyanate ester resin, a bis(bisphenylene)ethane resin and the like, and modified resins thereof are also included.

The substrate used in the invention preferably has a surface unevenness of 500 nm or less, more preferably 100 nm or less, even more preferably 50 nm or less, and most preferably 20 nm or less, when the uses thereof in semiconductor packaging, various electrical wiring boards and the like are taken into consideration. As this surface unevenness of the substrate (when an intermediate layer or a polymerization initiating layer is provided, the surface unevenness of that layer) is decreased, when the obtained metal-clad substrate is applied to wiring or the like, the electricity loss upon high frequency electric supply is reduced, which is preferable.

According to the invention, if the substrate is a plate-shaped object, for example, a resin film (plastic film), resin layers may be formed on both surfaces of the resin film by carrying out the step (a) on both surfaces of the film.

As such, when resin layers are formed on both surfaces of a resin film (substrate), a metal-clad substrate having plating films formed on both surfaces may be obtained by further carrying out the step (b) that will be described below.

According to the invention, in the case of using a surface graft polymerization method of providing an active species on the surface of a substrate and producing a graft polymer using the active species as a starting point, a substrate containing a polymerization initiator (a compound capable of generating an active species) or a substrate having a polymerization initiating layer having a functional group capable of initiating polymerization, may be used upon the production of a graft polymer. Specific examples of the compound capable of generating an active species include the polymerization initiators described in paragraphs [0043] and [0044] of JP-A No. 2007-154306. Here, the amount of the polymerization initiator incorporated in the polymerization initiating layer is preferably 0.1 to 50% by mass, and more preferably 1.0 to 30% by mass, of the solids content.

If the base material having this polymerization initiating layer formed therein is a plate-shaped object, the polymerization initiating layer may be formed on both surfaces of the base material.

Furthermore, for the purpose of enhancing the adhesiveness between the substrate and the resin layer, an adhesion aiding layer such as described below may also be formed between the substrate and the resin layer.

It is preferable for the adhesion aiding layer to be formed using a resin composition having satisfactory adhesiveness to the substrate and the resin layer to be formed. This adhesion aiding layer may contain a compound which generates an active site upon forming a resin layer formed from a resin chemically bound to the substrate, or may contain a compound which has an area capable of generating such an active site and an area capable of forming a chemical bonding with the substrate. As the adhesion aiding layer contains such a compound, the adhesion aiding layer functions as the polymerization initiating layer as described above.

In regard to the adhesion aiding layer according to the invention, for example, when the substrate is formed from a known insulating resin that has been used as a material for multilayer laminate boards, build-up boards or flexible boards, it is preferable to use an insulating resin composition also as the resin composition used upon forming the adhesion aiding layer, from the viewpoint of the adhesiveness to the substrate.

Now, an embodiment in which the substrate is formed from an insulating resin and the adhesion aiding layer is formed from an insulating resin composition, will be described below.

The insulating resin composition that is used for forming the adhesion aiding layer may contain the same electrically insulating resin as that constitutes the substrate, or may contain a different resin, but it is preferable to use a resin that is close to the insulating resin that constitutes the substrate, in terms of thermal properties such as glass transition temperature, elastic modulus and coefficient of linear expansion. Specifically, it is preferable to use, for example,

an insulating resin of the same type as the insulating resin that constitutes the base material, in view of adhesiveness.

The insulating resin according to the invention means a resin having insulating properties to the extent that the resin can be used in a known insulating film, and any resin that has insulating properties adequate for the purpose, even though it may not be a perfect insulator, may be applied in the invention.

Specifically, the insulating resin may be, for example, a thermosetting resin or a thermoplastic resin, or may be a mixture thereof. Examples of the thermosetting resin include an epoxy resin, a phenolic resin, a polyimide resin, a polyester resin, a bismaleimide resin, a polyolefin-based resin, an isocyanate-based resin and the like.

Examples of the thermoplastic resin include a phenoxy resin, polyether sulfone, polysulfone, polyphenylene sulfone, polyphenylene sulfide, polyphenyl ether, polyether imide, and the like.

The thermoplastic resin and the thermosetting resin may be used singly, or may also be used in combination of two or more kinds. This is implemented for the purpose of exhibiting excellent effects by complementing the flaws of the respective resins.

A resin having a skeleton capable of generating an active site on the occasion of forming a resin layer formed from a resin chemically bound to the substrate, may also be used as the insulating resin used in the adhesion aiding layer. An example of this resin that may be used is a polyimide having a polymerization initiation site in the skeleton, as described in paragraphs [0018] to [0078] of JP-A No. 2005-307140.

Furthermore, the adhesion aiding layer may contain a compound having a polymerizable double bond, specifically, an acrylate or methacrylate compound, in order to allow crosslinking to proceed within the layer, and it is particularly preferable to use a polyfunctional compound. In addition to that, a resin obtained by partially (meth)acrylating a thermosetting resin or a thermoplastic resin such as, for example, an epoxy resin, a phenolic resin, a polyimide resin, a polyolefin resin or a fluororesin, using methacrylic acid, acrylic acid or the like, may also be used as the compound having a polymerizable double bond.

The adhesion aiding layer according to the invention may further have various compounds added according to the purpose, to the extent of not impairing the effects of the invention.

Specific examples of the additives include a material capable of relieving stress upon heating, such as rubber or SBR latex, a binder for improving film properties, a plasticizer, a surfactant, a viscosity adjusting agent, and the like.

The adhesion aiding layer according to the invention may also use a composite (composite material) of a resin and another component, so as to strengthen the properties of the resin film, such as mechanical strength, heat resistance, weather resistance, flame retardancy, water resistance and electrical properties. Examples of the material used in producing a composite include paper, glass fiber, silica particles, a phenolic resin, a polyimide resin, a bismaleimide triazine resin, a fluororesin, a polyphenylene oxide resin, and the like.

The adhesion aiding layer may also contain inorganic or organic particles as a component other than the insulating resin, in order to enhance the strength of the adhesion aiding layer and to improve electrical properties. Specific examples thereof include fillers used in general resin materials for wiring boards, for example, inorganic fillers such as silica, alumina, clay, talc, aluminum hydroxide and calcium carbonate, and organic fillers such as a cured epoxy resin, a crosslinked benzoguanamine resin and a crosslinked acrylic polymer.

Furthermore, the adhesion aiding layer may also contain, if necessary, one or two or more kinds of various additives such as a colorant, a flame retardant, a tackifying agent, a silane coupling agent, an oxidation inhibitor and an ultraviolet absorbent.

When these materials are added, the materials are all added preferably in an amount in the range of 0 to 200% by mass, and more preferably in the range of 0 to 80% by mass, based on the resin which constitutes a main component. When the substrate adjacent to the adhesion aiding layer exhibits thermal or electrical property values that are equal or close to those of the adhesion aiding layer, it is not essentially necessary to add these additives. When the additives are used in an amount exceeding 200% by mass based on the resin, there is a fear that the properties inherent to the resin itself, such as strength, may be decreased.

It is preferable that the adhesion aiding layer make use of a compound capable of generating an active site on the occasion of forming a resin layer formed from a resin chemically bound to the substrate, as described above. In order to generate this active site, certain energy may be applied, and preferably light (ultraviolet rays, visible rays, X-rays or the like), plasma (oxygen, nitrogen, carbon dioxide, argon or the like), heat, electricity or the like is used. Furthermore, an active site may also be generated by chemically degrading the surface using an oxidizing liquid (a solution of potassium permanganate) or the like.

Examples of the compound capable of generating an active species include, for example, the thermal polymerization initiators and photopolymerization initiators described in paragraphs [0043] and [0044] ofJP-A No. 2007-154306.

Here, the amount of the polymerization initiator contained in the adhesion aiding layer is preferably 0.1 to 50% by mass, and more preferably 1.0 to 30% by mass, based on the solids content.

The adhesion aiding layer according to the invention is formed by disposing a resin composition for forming an adhesion aiding layer on a substrate by coating or the like, and eliminating the solvent.

The solvent used when this resin composition is prepared into a coating liquid, is not particularly limited if the

solvent dissolves the components constituting the adhesion aiding layer. From the viewpoints of the ease of drying and workability, a solvent having a boiling point that is not excessively high is preferable, and specifically, a solvent having a boiling point of about 40°C to 150°C may be selected.

Specifically, cyclohexanone, methyl ethyl ketone and the like as described in paragraph [0045] of JP-A No. 2007-154306 may be used. The solvents may be used singly or as mixtures. The concentration of the solids in the coating solution is suitably 2 to 50% by mass.

The amount of coating used in the case of forming an adhesion aiding layer on a substrate, in terms of mass after drying, is preferably 0.1 to 20 $g/m^2$, more preferably 0.1 to 15 $g/m^2$, and even more preferably 0.1 to 2 $g/m^2$, from the viewpoints of exhibiting sufficient adhesiveness and preventing the peel-off of a film by maintaining the film properties.

According to the invention, the adhesion aiding layer is formed as a film is formed by disposing a resin composition on a substrate and eliminating the solvent, as described above, but in this case, it is preferable to preliminarily cure the film by heating and/or photo-irradiation. Particularly, when the film is preliminarily cured by drying by heating and then performing photo-irradiation, curing is preliminarily carried out to an extent corresponding to the presence of the compound having a polymerizable double bond. Therefore, the situation in which after an adhesion aiding layer is formed on the resin layer, the whole adhesion aiding layer falls off, may be effectively prevented, which is preferable.

In regard to the heating temperature and time, those conditions under which the coating solvent can sufficiently dry up may be selected, but in view of the appropriateness for production, it is preferable to select a temperature of 100°C or lower, and a drying time of 30 minutes or less, and it is more preferable to select heating conditions in the range of a drying temperature of 40 to 80°C and a drying time of 10 minutes or less.

Furthermore, the adhesion aiding layer may be further subjected to a curing treatment of applying any energy, in addition to the preliminary film curing as described above. Examples of the energy that is applicable include light, heat, pressure, an electron beam and the like, but heat or light is general for the present exemplary embodiment, and in the case of heat, it is preferable to add heat at 100°C to 300°C for 5 minutes to 120 minutes. The conditions for curing by heating may vary with the type of the material of the substrate, the type of the resin composition that constitutes the adhesion aiding layer, and the like, and also with the curing temperature of these materials. However, it is preferable to select a temperature in the range of 120 to 220°C and a curing time in the range of 20 minutes to 120 minutes.

Such a curing treatment as described above may be carried out immediately after the formation of the adhesion aiding layer, and if a preliminary curing treatment which takes for about 5 to 10 minutes is to be carried out after the formation of the adhesion aiding layer, the curing treatment may be carried out after all of those other respective steps that follow the formation of the adhesion aiding layer have been completed.

The adhesion aiding layer may also be formed by applying a known layer forming method such as a transfer method or a printing method, in addition to the above-described coating method.

In the case of applying a transfer method, it is also acceptable to produce a transfer laminate having a bilayer construction of a layer obtained from the coating liquid for forming a resin layer and an adhesion aiding layer, and to transfer the laminate onto the surface of a substrate all at once according to a lamination method.

The thicknesses of the polymerization initiating layer and the adhesion aiding layer according to the invention are generally in the range of 0.1 μm to 10 μm, and preferably in the range of 0.2 μm to 5 μm. When a polymerization initiating layer and an adhesion aiding layer are provided, if the thickness falls in the range that is defined to be general, a sufficient strength for adhesion to the adjacent substrate or resin layer may be obtained. Furthermore, while the layers are thinner as compared with the case of using a common adhesive, an adhesiveness equal to that of a layer formed from the adhesive may be achieved. As a result, a metal-clad substrate having a small overall thickness and excellent adhesiveness may be obtained.

The surfaces of the polymerization initiating layer and the adhesive aiding layer according to the invention are such that the arithmetic average surface roughness Ra defined in JIS B 0633 (2001) is preferably 1 μm or less, and Ra is more preferably 0.5 μm or less, from the viewpoint of enhancing the properties of the formed metal plating film, or from the viewpoint of obtaining a printed wiring board having a fine circuit from the metal-clad substrate. When the surface smoothness of the polymerization initiating layer and the adhesion aiding layer falls in the range of the above-mentioned values, that is, the surface is in a state of having high smoothness, the metal-clad substrate is suitably used when a printed wiring board having a very fine circuit (for example, a circuit pattern having a line/space value of 25/25 μm or less).

After the formation of the polymerization initiating layer and the adhesion aiding layer, the surface may be roughened by a dry method and/or a wet method, for the purpose of enhancing the adhesiveness to the resin layer formed on the surface. Examples of the dry roughening method include mechanical polishing such as buffing and sand blasting, and plasma etching. On the other hand, examples of the wet roughening method include chemical treatments, such as a method of using an oxidizing agent such as permanganate, bichromate, ozone, hydrogen peroxide/sulfuric acid or nitric acid, and a method of using a strong base or a resin swelling solvent.

(Formation of resin layer formed from resin chemically bound to substrate)

Methods that may be used as the method for forming a resin layer formed from a resin chemically bound to the substrate in the step (a), include a method of using a coupling reaction between the functional group present at the substrate surface and the reactive functional group carried by a polymer compound at its terminus or in a side chain, and a surface graft polymerization method, as described above.

Furthermore, it is preferable that the resin layer according to the invention contain a resin having a functional group which is capable of forming interaction with the plating catalyst or a precursor thereof, from the viewpoint of forming a stable plating film by fixing the catalyst or the precursor present in the resin layer. Among others, it is preferable that the resin layer be formed from a composition containing a compound which has a functional group capable of forming interaction with the plating catalyst or the precursor, and a polymerizable group.

The resin layer of this preferred aspect will be explained below.

According to the invention, it is preferable to utilize an aspect in which a substrate having a polymerization initiating layer formed on a base material is used, a compound having a functional group which is capable of forming interaction with the plating catalyst or a precursor thereof (hereinafter, appropriately referred to as interactable group) and a polymerizable group is contacted with the polymerization initiating layer on top thereof, and then energy is applied thereto, so that the compound is directly chemically bound to the surface of the substrate (if a polymerization initiating layer is present, the surface of the layer) through polymerization. That is, when an active species is generated at the surface of the substrate by energy application, a polymerization reaction of the compound having an interactable group and a polymerizable group proceeds from the active species as a starting point. As a result, a form in which a resin having an interactable group (graft polymer) is chemically bound to the surface of the substrate may be obtained.

The contact may be carried out by immersing the substrate having a polymerization initiating layer formed thereon into a liquid composition containing the compound having an interactable group and a polymerizable group. However, from the viewpoint of handlability or production efficiency, it is preferable to form a layer formed from a composition containing the compound having an interactable group and a polymerizable group on the substrate surface (surface of the polymerization initiating layer) by a coating method, as will be described later.

Also in the case of forming resin layers on both surfaces of the resin film, it is preferable to use a coating method, from the viewpoint that it is easy to simultaneously form resin layers on both surfaces.

The compound having an interactable group and a polymerizable group, which is preferably used when a graft polymer is produced by a surface graft polymerization method according to the invention, will be explained.

The polymerizable group in the compound having an interactable group and a polymerizable group according to the invention is a functional group through which the compound having an interactable group and a polymerizable group reacts intermolecularly, and/or the compound having an interactable group and a polymerizable group binds to the substrate, when energy is applied. Specific examples of the polymerizable group include a vinyl group, a vinyloxy group, an allyl group, an acryloyl group, a methacryloyl group, an oxetane group, an epoxy group, an isocyanate group, a functional group containing active hydrogen, the active group in an azo compound, and the like.

Examples of the interactable group according to the invention include a polar group (hydrophilic group), a group capable of forming polydentate coordination, and non-dissociable functional groups such as a nitrogen-containing functional group, a sulfur-containing functional group and an oxygen-containing functional group (functional groups that do not produce proton by dissociation). Particularly, in order to reduce water absorbability and moisture absorbability of the metal-clad substrate obtained by the method for producing a metal-clad substrate of the invention, it is preferable to use a non-dissociable functional group as the site representing an interactable group.

The polar group may be a functional group having a positive charge, such as ammonium or phosphonium; or an acidic group which has a negative charge or can be dissociated into a negative charge, such as a sulfonic acid group, a carboxyl group, a phosphoric acid group or a phosphonic acid group. These adsorb to metal ions in the form of a counterion of the dissociating group.

Furthermore, for example, a nonionic polar group such as a hydroxyl group, an amide group, a sulfonamide group, an alkoxy group or a cyano group may also be used.

In addition to that, an imino group, a primary or secondary amino group, an amide group, a urethane group, a hydroxyl group (including phenol), a thiol group or the like may also be used.

Specifically, a group capable of coordinating with a metal ion, a nitrogen-containing functional group, a sulfur-containing functional group, an oxygen-containing functional group and the like are preferable as the non-dissociable functional group, and specific examples include nitrogen-containing functional groups such as an imide group, a pyridine group, a tertiary amino group, an ammonium group, a pyrrolidone group, an amidino group, a group containing a triazine cyclic structure, a group containing an isocyanuric structure, a nitro group, a nitroso group, an azo group, a diazo group, an azide group, a cyano group and a cyanate group (R-O-CN); oxygen-containing functional groups such as an ether group, a carbonyl group, an ester group, a group containing an N-oxide structure, a group containing an S-oxide structure and a group containing an N-hydroxyl structure; sulfur-containing functional groups such as a thioether group, a thioxy

group, a sulfoxide group, a sulfone group, a sulfite group, a group containing a sulfoximine structure, a group containing a sulfoxinium salt structure, and a group containing a sulfonic acid ester structure; phosphorus-containing functional groups such as a phosphine group; groups containing halogen atoms such as chlorine and bromine; an unsaturated ethylene group; and the like. Furthermore, in an aspect of representing non-dissociation properties due to the relationship with the adjacent atom or atomic group, an imidazole group, a urea group or a thiourea group may be used.

Among them, an ether group (more specifically, a structure represented by $-O-(CH_2)_n-O-$ (n is an integer from 1 to 5)) or a cyano group is particularly preferable, and a cyano group is most preferable, from the viewpoint of exhibiting high polarity and high adsorption capacity to plating catalyst or the like.

In general, there is a tendency that an increase in polarity leads to an increase in the water absorption ratio, but since cyano groups interact with each other so as to cancel the polarity of each other in the resin layer, the film becomes dense, while water absorbability is lowered because the overall polarity of the resin layer is decreased. Also, when a catalyst is adsorbed using a good solvent of the resin layer, the cyano group is solvated, and thus the interaction between cyano groups disappears, thereby making the cyano group capable of interacting with the plating catalyst. As discussed above, a resin layer having a cyano group is preferred from the viewpoint of exhibiting contradictory performances, such as being less moisture absorbable while highly interacting with the plating catalyst.

Furthermore, the interactable group according to the invention is more preferably an alkylcyano group. This is preferred from the viewpoint of adsorbability to plating catalyst or the like, because while an aromatic cyano group has electrons withdrawn to the aromatic ring and has a lower donating property for unpaired electrons, which are important in terms of the adsorbability to plating catalyst or the like, an alkylcyano group does not have this aromatic ring bound thereto.

According to the invention, the compound having an interactable group and a polymerizable group may be in any form of a monomer, a macromonomer or a polymer, and among them, it is preferable to use a polymer (a polymer having an interactable group and a polymerizable group) from the viewpoint of the properties for the formation of resin layer and the ease of control.

The polymer having an interactable group and a polymerizable group is preferably a polymer obtained by introducing an ethylene addition polymerizable unsaturated group (polymerizable group) such as a vinyl group, an allyl group or a (meth)acryl group, as a polymerizable group, to a homopolymer or a copolymer obtainable by using a monomer having an interactable group. This polymer having an interactable group and a polymerizable group is a polymer having a polymerizable group at least at the end of the main chain or a side chain, and a polymer having a polymerizable group in a side chain is preferred.

Hereinafter, the compound having an interactable group and a polymerizable group, which has a non-dissociable functional group as the interactable group, will be described in detail.

In regard to the monomer having an interactable group that is used to obtain the polymer having an interactable group and a polymerizable group, any monomer that has the non-dissociable functional group described above may be put to use, but specific examples thereof include the following.

These may be used singly, or may be used in combination of two or more kinds.

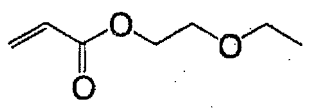
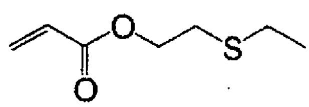
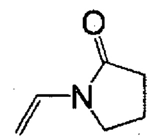

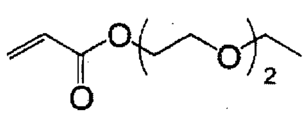
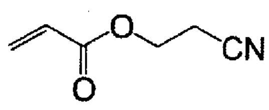
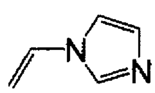

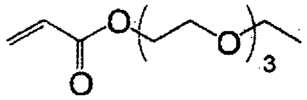
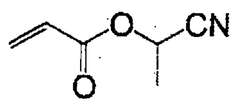
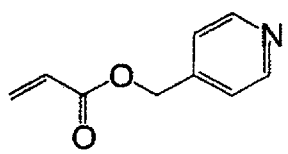

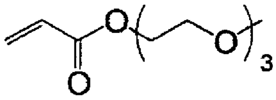
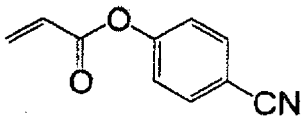
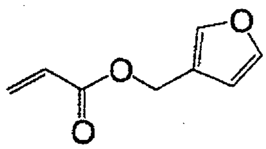

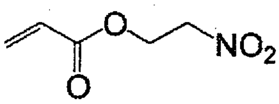
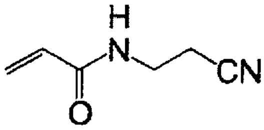
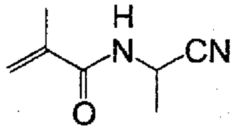

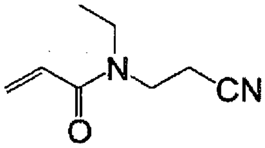

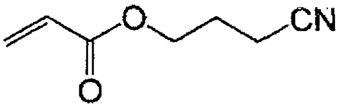
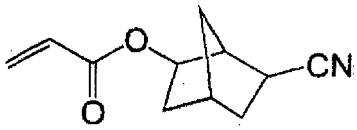

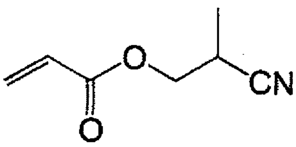
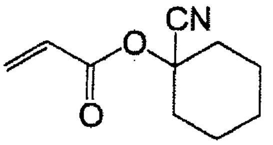

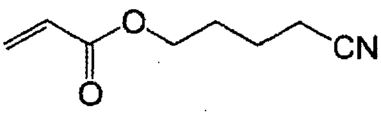
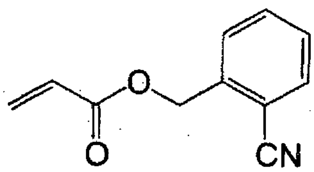

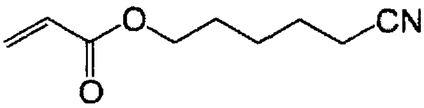

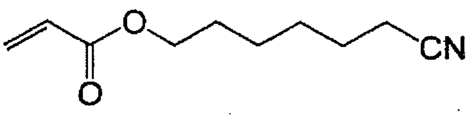
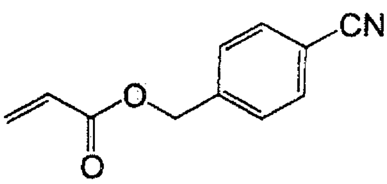

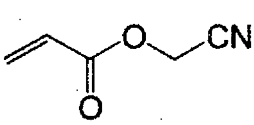

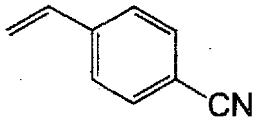

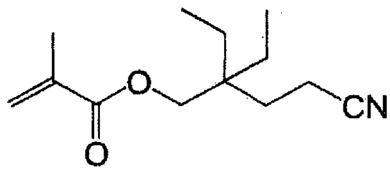

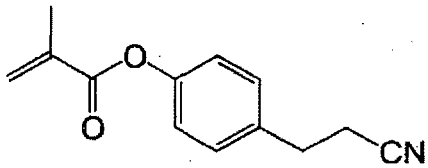

In regard to the polymer having an interactable group and a polymerizable group, the unit derived from a monomer having an interactable group is preferably contained in a content in the range of 50 to 95% by mole, and more preferably contained in a content in the range of 40 to 80% by mole, in the polymer having an interactable group and a polymerizable group, from the viewpoint of the properties for the formation of interaction with the plating catalyst or a precursor thereof.

Upon obtaining a polymer having an interactable group and a polymerizable group, other monomers may also be used in addition to the monomer having an interactable group, so as to lower water absorbability and to enhance hydrophobicity. General polymerizable monomers may be used as the other monomers, and examples include diene-based monomers, acrylic monomers and the like. Among them, an acrylic monomer of unsubstituted alkyl is preferred. Specifically, tertiary-butyl acrylate, 2-ethylhexyl acrylate, butyl acrylate, cyclohexyl acrylate, benzyl methacrylate, and the like may be preferably used.

Such a polymer having an interactable group and a polymerizable group may be synthesized as follows.

Examples of the synthesis method include i) a method of copolymerizing a monomer having an interactable group and a monomer having a polymerizable group; ii) a method of copolymerizing a monomer having an interactable group and a monomer having a double bond precursor, and then introducing a double bond by treating the product with a base or the like; and iii) a method of reacting a polymer having an interactable group with a monomer having a polymerizable group, and thereby introducing a double bond (introducing a polymerizable group). Preferred methods from the viewpoint of synthesis suitability are ii) a method of copolymerizing a monomer having an interactable group and a monomer having a double bond precursor, and then introducing a double bond by treating the product with a base or the like, and iii) a method of reacting a polymer having an interactable group with a monomer having a polymerizable group, and thereby introducing a polymerizable group.

Monomers similar to the monomers having an interactable group as described above may be used as the monomer having an interactable group, which is used in the synthesis of the polymer having an interactable group and a polymerizable group. The monomers may be used singly, or may be used in combination of two or more kinds.

Examples of the monomer having a polymerizable group, which is copolymerized with a monomer having an interactable group, include allyl (meth)acrylate, 2-allyloxyethyl methacrylate, and the like.

Examples of the monomer having a double bond precursor include 2-(3-chloro-1-oxopropoxy)ethyl methacrylate, 2-(3-bromo-1-oxopropoxy)ethyl methacrylate, and the like.

Furthermore, examples of the monomer having a polymerizable group, which is used to introduce an unsaturated group by using a reaction with a functional group in a polymer having an interactable group, such as a carboxyl group, an amino group or a salt thereof, a hydroxyl group or an epoxy group, include (meth)acrylic acid, glycidyl (meth)acrylate, allyl glycidyl ether, 2-isocyanatoethyl (meth)acrylate, and the like.

Hereinafter, specific examples of the polymer having an interactable group and a polymerizable group, which may be suitably used in the invention, will be presented below, but the invention is not intended to be limited to these.

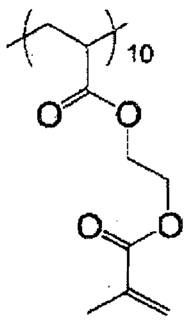

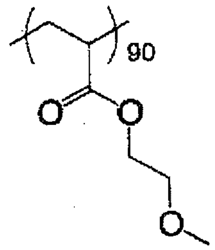

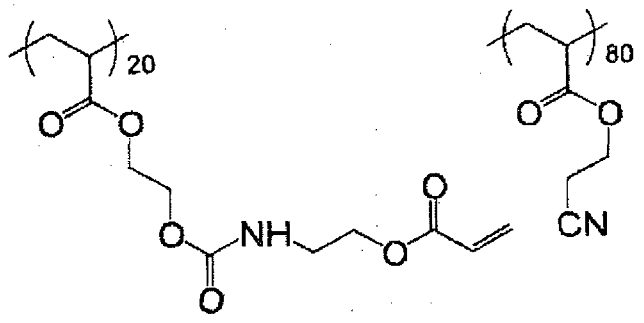

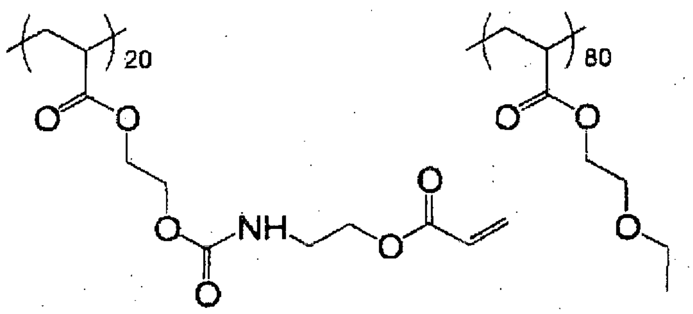

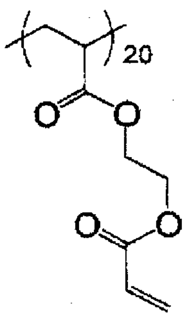

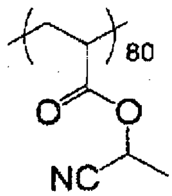

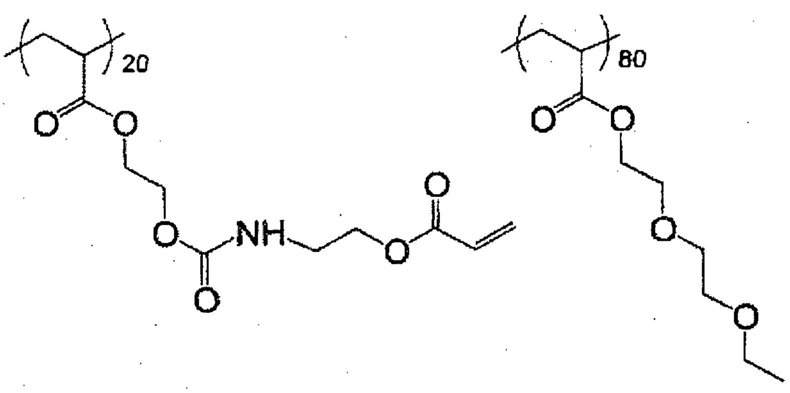

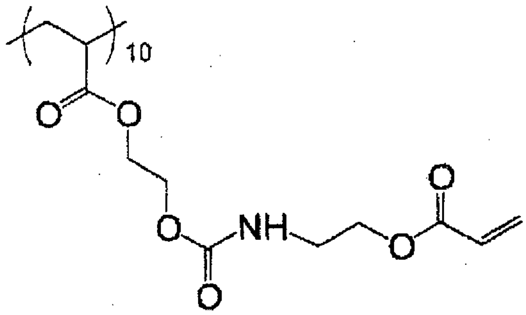

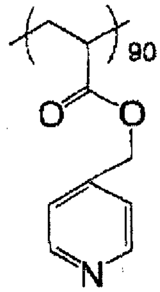

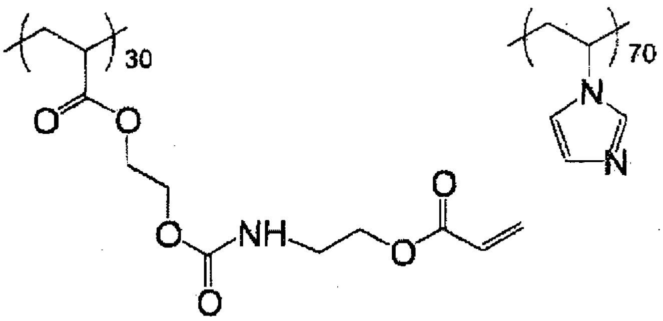

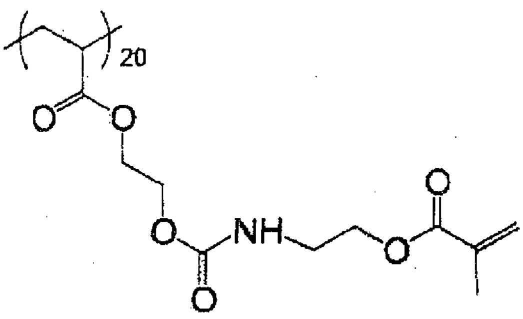

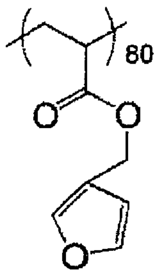

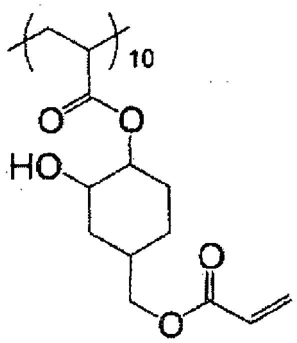

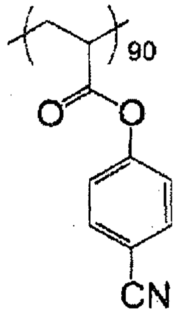

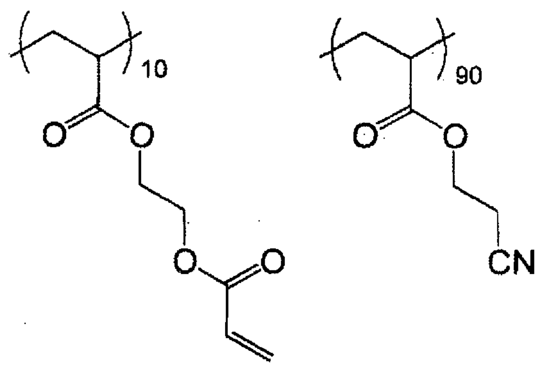

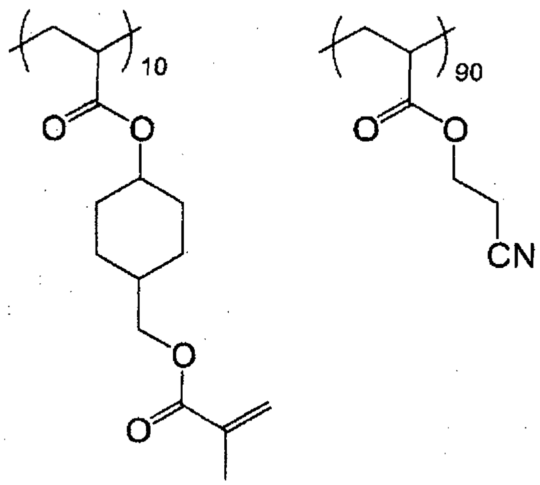

The polymer having an interactable group and a polymerizable group according to the invention is preferably a polymer having a cyano group as the interactable group (hereinafter, referred to as "cyano group-containing polymerizable polymer").

The cyano group-containing polymerizable polymer according to the invention is preferably, for example, a copolymer which contains a unit represented by the following formula (1) and a unit represented by the following formula (2).

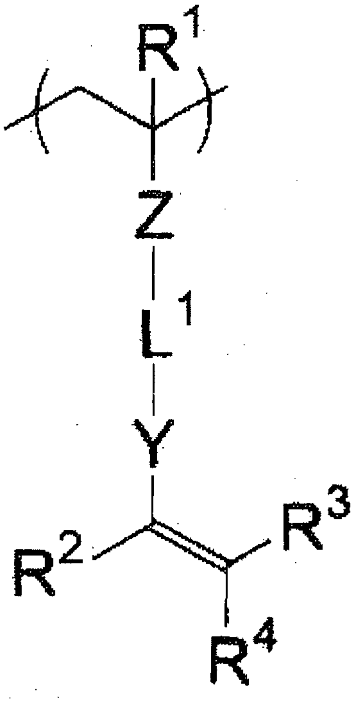

Formula (1)

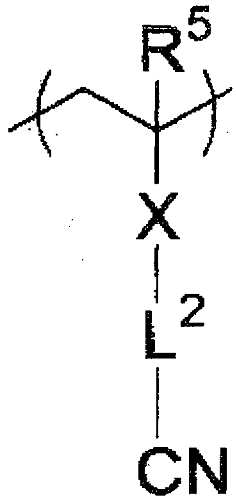

Formula (2)

In the formula (1) and formula (2), $R^1$ to $R^5$ each independently represent a hydrogen atom, or a substituted or unsubstituted alkyl group; X, Y and Z each independently represent a single bond, a substituted divalent organic group, an unsubstituted divalent organic group, an ester group, an amide group or an ether group; and $L^1$ and $L^2$ each independently represent a substituted or unsubstituted divalent organic group.

When $R^1$ to $R^5$ each represent a substituted or unsubstituted alkyl group, examples of the unsubstituted alkyl group include a methyl group, an ethyl group, a propyl group and a butyl group, and examples of the substituted alkyl group include a methyl group, an ethyl group, a propyl group and a butyl group, each substituted a methoxy group, a hydroxyl group, a chlorine atom, a bromine atom, a fluorine atom or the like.

$R^1$ is preferably a hydrogen atom, a methyl group, or a methyl group substituted with a hydroxyl group or a bromine atom.

$R^2$ is preferably a hydrogen atom, a methyl group, or a methyl group substituted with a hydroxyl group or a bromine atom.

$R^3$ is preferably a hydrogen atom.

$R^4$ is preferably a hydrogen atom.

$R^5$ is preferably a hydrogen atom, a methyl group, or a methyl group substituted with a hydroxyl group or a bromine atom.

When X, Y and Z each represent a substituted or unsubstituted divalent organic group, examples of the divalent organic group include a substituted or unsubstituted aliphatic hydrocarbon group, and a substituted or unsubstituted aromatic hydrocarbon group.

The substituted or unsubstituted aliphatic hydrocarbon group is preferably a methylene group, an ethylene group, a propylene group, a butylene group, or each of these groups substituted with a methoxy group, a hydroxyl group, a chlorine atom, a bromine atom, a fluorine atom or the like.

The substituted or unsubstituted aromatic hydrocarbon group is preferably an unsubstituted phenyl group, or a phenyl group substituted with a methoxy group, a hydroxyl group, a chlorine atom, a bromine atom, a fluorine atom or the like.

Among them, $-(CH_2)_n-$ (n is an integer from 1 to 3) is preferred, and $-CH_2-$ is more preferred.

$L^1$ is preferably a divalent organic group having a urethane bond or a urea bond, and more preferably a divalent organic group having a urethane bond. Among them, such a group having a total carbon number of 1 to 9 is preferred. Here, the total carbon number of $L^1$ means the total number of carbon atoms contained in the substituted or unsubstituted divalent organic group represented by $L^1$.

More specifically, the structure of $L^1$ is preferably a structure represented by the following formula (1-1) or formula (1-2).

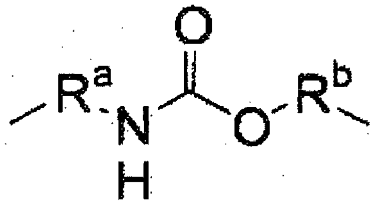

Formula (1-1)

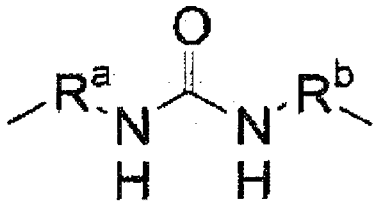

Formula (1-2)

In the formula (1-1) and formula (1-2), $R^a$ and $R^b$ each independently represent a divalent organic group formed by using two or more atoms selected from the group consisting of a carbon atom, a hydrogen atom and an oxygen atom, and preferred examples thereof include a methylene group, an ethylene group, a propylene group and a butylene group, each being substituted or unsubstituted, as well as an ethylene oxide group, a diethylene oxide group, a triethylene oxide group, a tetraethylene oxide group, a dipropylene oxide group, a tripropylene oxide group, and a tetrapropylene oxide group.

$L^2$ is preferably a straight-chained, branched or cyclic alkylene group, an aromatic group, or a group obtained by combining these. The group obtained by combining an alkylene group and an aromatic group may be further interrupted by an ether group, an ester group, an amide group, a urethane group or a urea group. Among them, $L^2$ is preferably such a group having a total carbon number of 1 to 15, and particularly preferably an unsubstituted group. Here, the total carbon number of $L^2$ means the total number of carbon atoms contained in the substituted or unsubstituted divalent organic group represented by $L^2$.

Specific examples thereof include a methylene group, an ethylene group, a propylene group, a butylene group, a phenylene group, and these groups substituted with a methoxy group, a hydroxyl group, a chlorine atom, a bromine atom, a fluorine atom or the like, and also include groups obtained by combining these.

For the cyano group-containing polymerizable polymer according to the invention, the unit represented by the formula (1) is preferably a unit represented by the following formula (3).

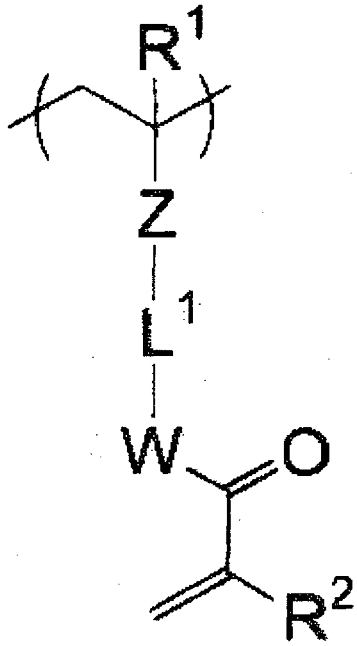

Formula (3)

In the formula (3), $R^1$ and $R^2$ each independently represent a hydrogen atom, or a substituted or unsubstituted alkyl group; Z represents a single bond, a substituted or unsubstituted divalent organic group, an ester group, an amide group or an ether group; W represents an oxygen atom, or NR (wherein R represents a hydrogen atom or an alkyl group,

and is preferably a hydrogen atom, or an unsubstituted alkyl group having 1 to 5 carbon atoms); and $L^1$ represents a substituted or unsubstituted divalent organic group.

$R^1$ and $R^2$ in the formula (3) have the same definitions as defined for $R^1$ and $R^2$ in the formula (1), respectively, and also have the same preferable definitions as defined for $R^1$ and $R^2$ in the formula (1), respectively.

Z in the formula (3) has the same definition as defined for Z in the formula (1), and also has the same preferable definition as defined for Z in the formula (1).

$L^1$ in the formula (3) has the same definition as defined for $L^1$ in the formula (1), and also has the same preferable definition as defined for $L^1$ in the formula (1).

For the cyano group-containing polymerizable polymer according to the invention, the unit represented by the formula (3) is preferably a unit represented by the following formula (4).

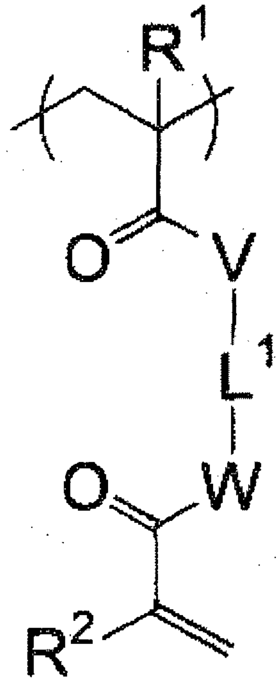

Formula (4)

In the formula (4), $R^1$ and $R^2$ each independently represent a hydrogen atom, or a substituted or unsubstituted alkyl group; V and W each independently represent an oxygen atom, or NR (wherein R represents a hydrogen atom or an alkyl group, and is preferably a hydrogen atom or an unsubstituted alkyl group having 1 to 5 carbon atoms); and $L^1$ represents a substituted or unsubstituted divalent organic group.

$R^1$ and $R^2$ in the formula (4) have the same definitions as defined for $R^1$ and $R^2$ in the formula (1), respectively, and also have the same preferable definitions as defined for $R^1$ and $R^2$ in the formula (1), respectively.

$L^1$ in the formula (4) has the same definition as defined for $L^1$ in the formula (1), and also has the same preferable definition as defined for $L^1$ in the formula (1).

In the formula (3) and formula (4), W is preferably an oxygen atom.

In the formula (3) and formula (4), $L^1$ is preferably an unsubstituted alkylene group, or a divalent organic group having a urethane bond or a urea bond, and more preferably a divalent organic group having a urethane bond. Among these, such a group having a total carbon number of 1 to 9 is particularly preferred.

For the cyano group-containing polymerizable polymer according to the invention, the unit represented by the formula (2) is preferably a unit represented by the following formula (5).

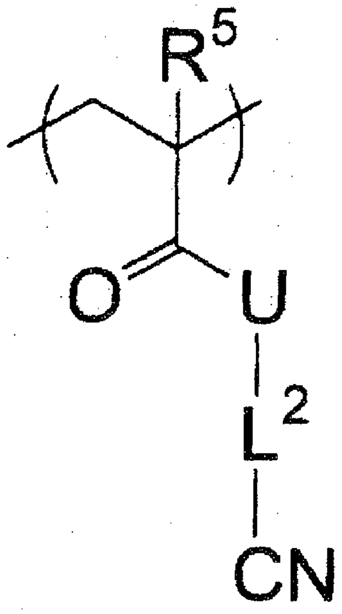

Formula (5)

In the formula (5), $R^5$ represents a hydrogen atom, or a substituted or unsubstituted alkyl group; U represents an oxygen atom, or NR' (wherein R' represents a hydrogen atom or an alkyl group, and is preferably a hydrogen atom or an unsubstituted alkyl group having 1 to 5 carbon atoms); and $L^2$ represents a substituted or unsubstituted divalent organic group.

$R^5$ in the formula (5) has the same definition as defined for $R^1$ and $R^2$ in the formula (1), and is preferably a hydrogen atom.

$L^2$ in the formula (5) has the same definition as defined for $L^2$ in the formula (2), and is preferably a straight-chained, branched or cyclic alkylene group, an aromatic group, or a group obtained by combining these.

Particularly, in the formula (5), the linking site to a cyano group in $L^2$ is preferably a divalent organic group having a straight-chained, branched or cyclic alkylene group, and among others, this divalent organic group is preferably such a group having a total carbon number of 1 to 10.

In another preferred aspect, the linking site to a cyano group in $L^2$ in the formula (5) is preferably a divalent organic group having an aromatic group, and among others, this divalent organic group is preferably such a group having a total carbon number of 6 to 15.

The cyano group-containing polymerizable polymer according to the invention is a polymer which is constituted to contain units represented by the formula (1) to (5) and has a polymerizable group and a cyano group in side chains.

This cyano group-containing polymerizable polymer may be synthesized, for example, as will be described below.

The type of the polymerization reaction used upon synthesizing the cyano group-containing polymerizable polymer according to the invention, may be radical polymerization, cationic polymerization or anionic polymerization. From the viewpoint of reaction control, it is preferable to use radical polymerization or cationic polymerization.

The synthesis method for the cyano group-containing polymerizable polymer according to the invention may be different between: 1) the case where the polymerization mode for forming the polymer main chain is different from the polymerization mode for the polymerizable group to be introduced into a side chain; and 2) the case where the polymerization mode for forming the polymer main chain is identical with the polymerization mode for the polymerizable group to be introduced into a side chain.

1) Case where the polymerization mode for forming the polymer main chain is different from the polymerization mode for the polymerizable group to be introduced into a side chain

Examples of the case where the polymerization mode for forming the polymer main chain is different from the polymerization mode for the polymerizable group to be introduced into a side chain, include: 1-1) an embodiment in which the formation of the polymer main chain is carried out by cationic polymerization, and the polymerization mode for the polymerizable group to be introduced into a side chain is radical polymerization; and 1-2) an aspect in which the

formation of the polymer main chain is carried out by radical polymerization, and the polymerization mode for the polymerizable group to be introduced into a side chain is cationic polymerization.

1-1) Aspect in which the formation of the polymer main chain is carried out by cationic polymerization and the polymerization mode for the polymerizable group to be introduced into a side chain is radical polymerization

According to the invention, the monomers used in the aspect in which the formation of the polymer main chain is carried out by cationic polymerization and the polymerization mode for the polymerizable group to be introduced into a side chain is radical polymerization, include the following compounds.

• Monomers used for forming polymerizable group-containing unit

Examples of the monomers used for forming the polymerizable group-containing unit that is used in this aspect include vinyl (meth)acrylate, allyl (meth)acrylate, 4-(meth)acryloylbutane vinyl ether, 2-(meth)acryloylethane vinyl ether, 3-(meth)acryloylpropane vinyl ether, (meth)acryloyloxydiethylene glycol vinyl ether, (meth)acryloyloxytriethylene glycol vinyl ether, (meth)acryloyl 1st terpionel, 1-(meth)acryloyloxy-2-methyl-2-propene, 1-(meth)acryloyloxy-3-methyl-3-butene, 3-methylene-2-(meth)acryloyloxynorbornane, 4,4'-ethylidene diphenol di(meth)acrylate, methacrolein di(meth)acryloyl acetal, p-((meth)acryloylmethyl)styrene, allyl (meth)acrylate, vinyl 2-(bromomethyl)acrylate, allyl 2-(hydroxymethyl)acrylate, and the like.

• Monomers used for forming cyano group-containing unit

Examples of the monomers used for forming the cyano group-containing unit that is used in this aspect include 2-cyanoethyl vinyl ether, cyanomethyl vinyl ether, 3-cyanopropyl vinyl ether, 4-cyanobutyl vinyl ether, 1-(p-cyanophenoxy)-2-vinyloxyethane, 1-(o-cyanophenoxy)-2-vinyloxyethane, 1-(m-cyanophenoxy)-2-vinyloxyethane, 1-(p-cyanophenoxy)-3-vinyloxypropane, 1-(p-cyanophenoxy)-4-vinyloxybutane, o-cyanobenzyl vinyl ether, m-cyanobenzyl vinyl ether, p-cyanobenzyl vinyl ether, allyl cyanide, allyl cyanoacetate, and the following compounds.

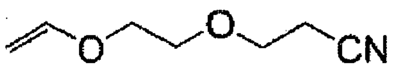
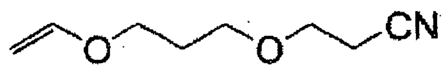
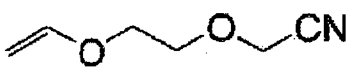
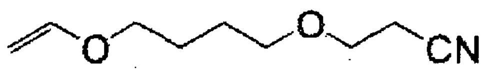
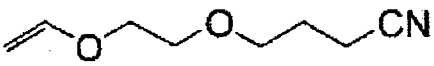
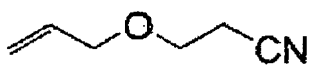
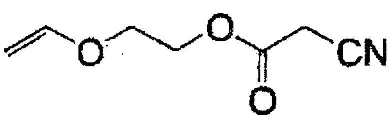
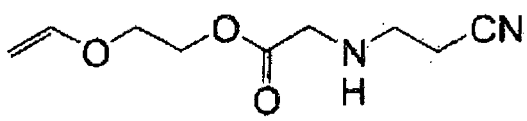

Polymerization may be carried out using the method described in Lectures on Experimental Chemistry "Polymer Chemistry," Chapter 2-4 (p. 74), or the general cationic polymerization method described in "Experimental Methods for Polymer Synthesis," written by Otsu Takayuki, Chapter 7 (p. 195). In the cationic polymerization, a protic acid, a halogenated metal, an organometallic compound, an organic salt, a metal oxide, a solid acid or halogen may be used as an initiator, and among these, it is preferable to use a halogenated metal or an organometallic compound as an initiator which has high activity and is capable of synthesizing a high molecular weight compound.

Specific examples include boron trifluoride, boron trichloride, aluminum chloride, aluminum bromide, titanium tetrachloride, tin tetrachloride, tin bromide, phosphorus pentafluoride, antimony chloride, molybdenum chloride, tungsten chloride, iron chloride, dichloroethylaluminum, chlorodiethylaluminum, dichloromethylaluminum, chlorodimethylaluminum, trimethylaluminum, trimethylzinc, and methyl Grignard.

-2) Aspect in which the formation of the polymer main chain is carried out by radical polymerization, and the polymerization mode for the polymerizable group to be introduced into a side chain is cationic polymerization.

According to the invention, the monomers used in the aspect in which the formation of the polymer main chain is carried out by radical polymerization and the polymerization mode for the polymerizable group to be introduced into a side chain is cationic polymerization, include the following compounds.

• Monomers used for forming polymerizable group-containing unit

The same monomers as those used for forming a polymerizable group-containing unit, as mentioned in the aspect of (1-1), may be used.

• Monomers used for forming cyano group-containing unit

Examples of the monomers used for forming the cyano group-containing unit that is used in this aspect, include cyanomethyl (meth)acrylate, 2-cyanoethyl (meth)acrylate, 3-cyanopropyl (meth)acrylate, 2-cyanopropyl (meth)acrylate, 1-cyanomethyl (meth)acrylate, 4-cyanobutyl (meth)acrylate, 5-cyanopentyl (meth)acrylate, 6-cyanohexyl (meth)acrylate, 7-cyanohexyl (meth)acrylate, 8-cyanohexyl (meth)acrylate, 2-cyanoethyl (3-(bromomethyl)acrylate), 2-cyanoethyl (3-(hydroxymethyl)acrylate), p-cyanophenyl (meth)acrylate, o-cyanophenyl (meth)acrylate, m-cyanophenyl (meth)acrylate, 5-(meth)acryloyl-2-carbonitrilonorbornene, 6-(meth)acryloyl-2-carbonitrilonorbomene, 1-cyano-1-(meth)acryloylcyclohexane, 1,1-dimethyl-1-cyano(meth)acrylate, 1-dimethyl-1-ethyl-1-cyano(meth)acrylate, o-cyanobenzyl (meth)acrylate, m-cyanobenzyl (meth)acrylate, p-cyanobenzyl (meth)acrylate, 1-cyanocycloheptyl acrylate, 2-cyanophenyl acrylate, 3-cyanophenyl acrylate, vinyl cyanoacetate, vinyl 1-cyano-1-cyclopropanecarboxylate, allyl cyanoacetate, allyl 1-cyano-1-cyclopropanecarboxylate, N,N-dicyanomethyl (meth)acrylamide, N-cyanophenyl (meth)acrylamide, allyl cyanomethyl ether, allyl-o-cyanoethyl ether, allyl-m-cyanobenzyl ether, allyl-p-cyanobenzyl ether, and the like.

Monomers having a structure in which a part of the hydrogen atoms of the above-mentioned monomers have been substituted by a hydroxyl group, an alkoxy group, a halogen, a cyano group or the like, may also be used.

Polymerization may be carried out using the method described in Lectures on Experimental Chemistry "Polymer Chemistry," Chapter 2-2 (p. 34), or the general radical polymerization method described in "Experimental Methods for Polymer Synthesis," written by Otsu Takayuki, Chapter 5 (p. 125). Known examples of the initiator for radical polymerization include a high-temperature initiator which requires heating to 100°C or above, an ordinary initiator which initiates by heating at 40 to 100°C, a redox initiator which initiates at very low temperature, and the like. However, an ordinary initiator is preferred from the viewpoint of easy handlability of polymerization reactions.

Examples of the ordinary initiator include benzoyl peroxide, lauroyl peroxide, peroxodisulfuric acid salts, azobisisobutyronitrile, and azobis-2,4-dimethylvaleronitrile.

2) Case where the polymerization mode for forming the polymer main chain is identical with the polymerization mode for the polymerizable group to be introduced into a side chain

Examples of the case where the polymerization mode for forming the polymer main chain is identical with the polymerization mode for the polymerizable group to be introduced into a side chain, include: 2-1) an aspect in which both polymerization modes involve cationic polymerization; and 2-2) an aspect in which both polymerization modes involve radical polymerization.

2-1) Aspect in which both polymerization modes involve cationic polymerization

According to the aspect in which both polymerization modes involve cationic polymerization, the same monomers as those used for forming a cyano group-containing unit mentioned for the aspect of (1-1) may be used as the monomer having a cyano group.

From the viewpoint of preventing gelation during polymerization, it is preferable to use a method of preliminarily synthesizing a polymer having a cyano group, subsequently reacting the polymer with a compound having a cationically polymerizing polymerizable group (hereinafter, appropriately referred to as "reactive compound"), and thereby introducing a cationically polymerizing polymerizable group into a side chain.

It is preferable that the polymer having a cyano group have a reactive group such as shown below, for the reaction with the reactive compound.

It is also preferable to appropriately select the polymer having a cyano group and the reactive compound, so as to form combinations of functional groups described below.

Specific examples of the combination include (reactive group of polymer, functional group of reactive compound)

= (carboxyl group, carboxyl group), (carboxyl group, epoxy group), (carboxyl group, isocyanate group), (carboxyl group, halogenated benzyl), (hydroxyl group, carboxyl group), (hydroxyl group, epoxy group), (hydroxyl group, isocyanate group), (hydroxyl group, halogenated benzyl), (isocyanate group, hydroxyl group), (isocyanate group, carboxyl group), and the like.

Here, specifically, compounds shown below may be used as the reactive compound.

That is, the compounds include allyl alcohol, 4-hydroxybutane vinyl ether, 2-hydroxyethane vinyl ether, 3-hydroxypropane vinyl ether, hydroxytriethylene glycol vinyl ether, 1st terpionel, 2-methyl-2-propenol, 3-methyl-3-butenol, 3-methylene-2-hydroxynorbomane, and p-(chloromethyl)styrene.

2-2) Embodiment in which both polymerization modes involve radical polymerization

According to the aspect in which both polymerization modes involve radical polymerization, examples of the synthesis method include: i) a method of copolymerizing a monomer having a cyano group and a monomer having a polymerizable group; ii) a method of copolymerizing a monomer having a cyano group and a monomer having a double bond precursor, and then introducing a double bond by treating the product with a base or the like; and iii) a method of reacting a polymer having a cyano group with a monomer having a polymerizable group, and thereby introducing a double bond (introducing a polymerizable group). Preferred methods from the viewpoint of synthesis suitability are ii) a method of copolymerizing a monomer having a cyano group and a monomer having a double bond precursor, and then introducing a double bond by treating the product with a base or the like, and iii) a method of reacting a polymer having a cyano group with a monomer having a polymerizable group, and thereby introducing a polymerizable group.

Examples of the monomer having a polymerizable group that is used in the synthesis method of (i) include allyl (meth)acrylate, and the following compounds.

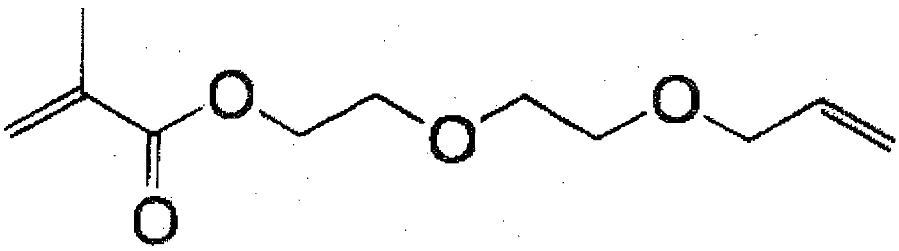

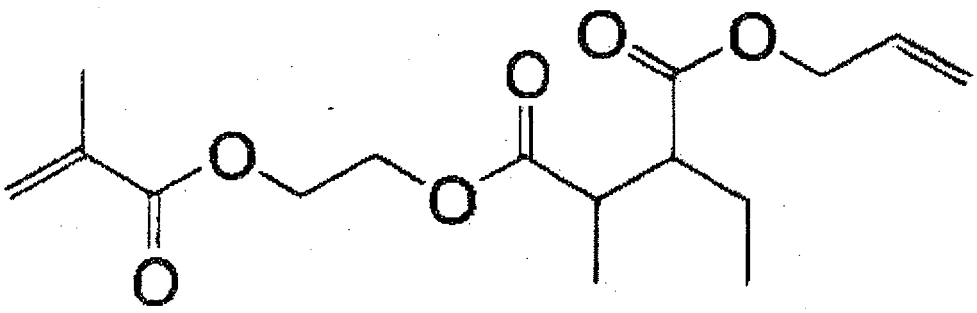

Examples of the monomer having a double bond precursor that is used in the synthesis method of (ii) include compounds represented by the following formula (a), and the like.

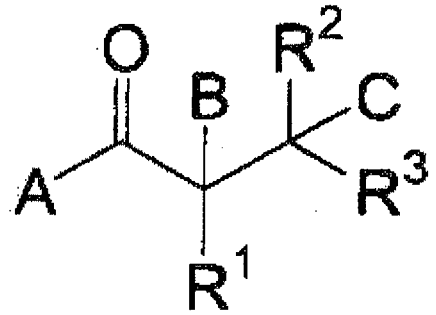

Formula (a)

In the formula (a), A represents an organic atomic group having a polymerizable group; $R^1$ to $R^3$ each independently represent a hydrogen atom, or a monovalent organic group; and B and C each represent an elimination group that is removed by an elimination reaction. The elimination reaction as used herein means that C is detached under the action of base, and B is eliminated. It is preferable that B be eliminated as an anion, and C be eliminated as a cation.

Specific examples of the compound represented by the formula (a) include the following compounds.

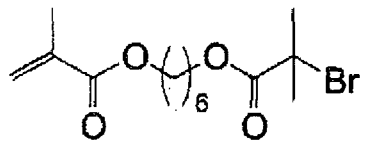
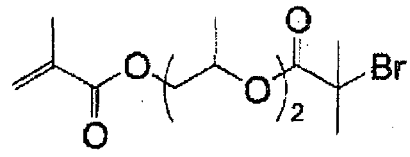
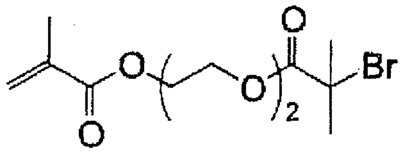
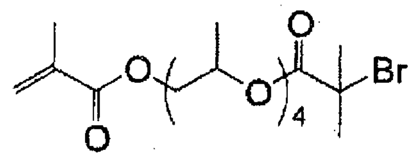
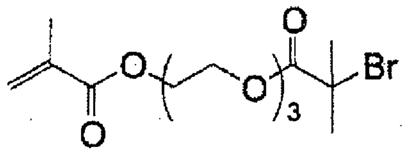
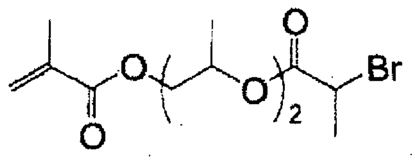
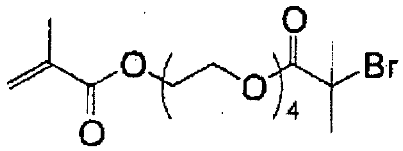
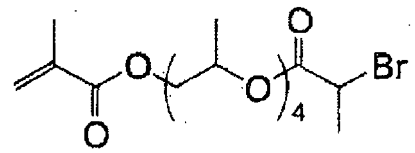
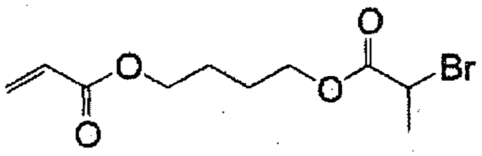
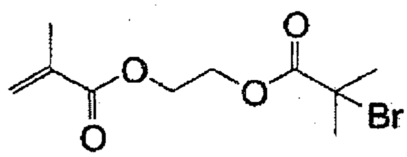
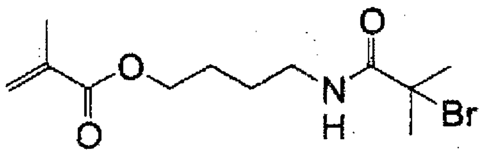
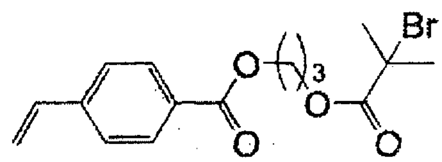
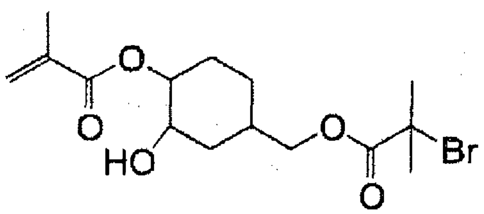
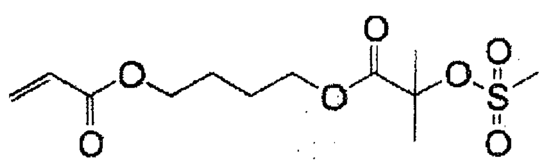

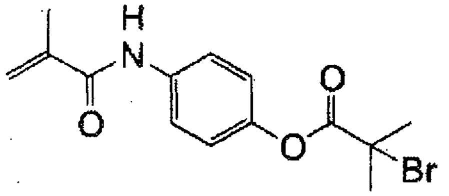

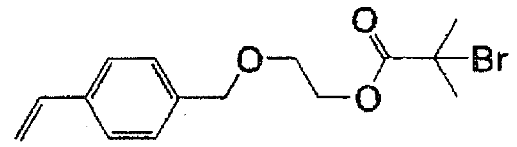

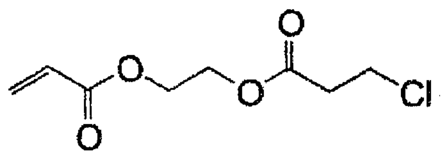

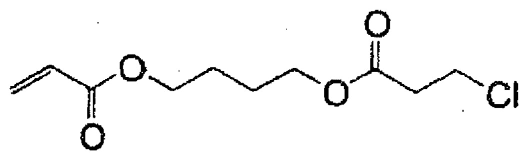

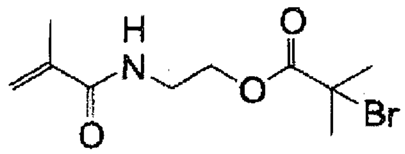

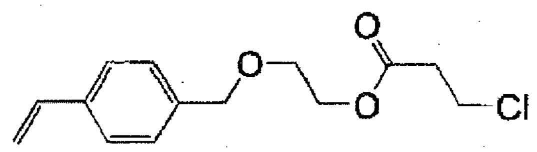

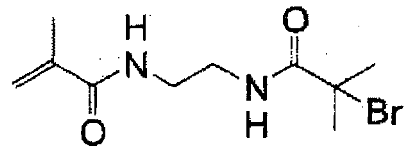

Furthermore, in order to convert the double bond precursor to a double bond in the synthesis method of (ii), a method of removing the elimination groups represented by B and C through elimination reactions as described below, that is, a reaction of detaching C under the action of base and eliminating B is used.

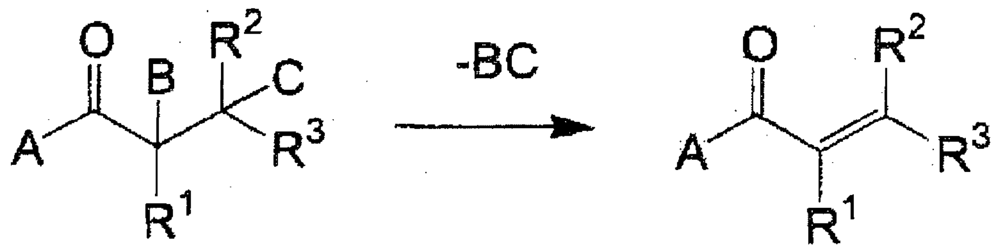


Preferred examples of the base used in the elimination reaction mentioned above include hydrides, hydroxides or carbonates of alkali metals, organic ami compounds, and metal alkoxide compounds. Preferred examples of the hydrides, hydroxides or carbonates of alkali metals include sodium hydride, calcium hydride, potassium hydride, sodium hydroxide, potassium hydroxide, calcium hydroxide, potassium carbonate, sodium carbonate, potassium hydrogen carbonate, sodium hydrogen carbonate, and the like. Preferred examples of the organic amine compounds include trimethylamine, triethylamine, diethylmethylamine, tributylamine, triisobutylamine, trihexylamine, trioctylamine, N,N-dimethylcyclohexylamine, N,N-diethylcyclohexylamine, N-methyldicyclohexylamine, N-ethyldicyclohexylamine, pyrrolidine, 1-methylpyrrolidine, 2,5-dimethylpyrrolidine, piperidine, 1-methylpiperidine, 2,2,6,6-tetramethylpiperidine, piperazine, 1,4-dimethylpiperazine, quinuclidine, 1,4-diazabicyclo[2,2,2]-octane, hexamethylenetetramine, morpholine, 4-methylmorpholine, pyridine, picoline, 4-dimethylaminopyridine, lutidine, 1,8-diazabicyclo[5,4,0]-7-undecene (DBU), N,N'-dicyclohexylcarbodiimide (DCC), diisopropylethylamine, Schiff base, and the like. Preferred examples of the metal alkoxide compounds include sodium methoxide, sodium ethoxide, potassium t-butoxide, and the like. These bases maybe used singly or as mixtures of two or more kinds.

Furthermore, examples of the solvent used upon applying (adding) a base to the elimination reaction, include ethylene dichloride, cyclohexanone, methyl ethyl ketone, acetone, methanol, ethanol, propanol, butanol, ethylene glycol monomethyl ether, ethylene glycol monoethyl ether, 2-methoxyethyl acetate, 1-methoxy-2-propanol, 1-methoxy-2-propyl acetate, N,N-dimethylformamide, N,N-dimethylacetamide, dimethylsulfoxide, toluene, ethyl acetate, methyl lactate, ethyl lactate, water, and the like. These solvents may be used singly or as mixtures of two or more kinds.

The amount of the base used may be an equivalent or less, or may be an equivalent or more, relative to the

amount of the specific functional groups (elimination groups represented by B and C) in the compound. When the base is used in excess, it is also a preferable embodiment to add an acid or the like for the purpose of eliminating the excess base after the elimination reaction.

The polymer having a cyano group that is used in the synthesis method of (iii), is synthesized by radical polymerizing the monomer used for forming a cyano group-containing unit that has been mentioned in the aspect of (1-2), and a monomer having a reactive group for introducing a double bond.

The monomer having a reactive group for introducing a double bond may be a monomer having a carboxyl group, a hydroxyl group, an epoxy group or an isocyanate group as the reactive group.

Examples of the carboxyl group-containing monomer include (meth)acrylic acid, itaconic acid, vinyl benzoate; ARONIX M-5300, M-5400 and M-5600 (trade names, manufactured by Toagosei Co., Ltd.); acrylic esters, PA and HH (trade names, manufactured by Mitsubishi Rayon Co., Ltd.); light acrylate, HOA-HH (trade name, manufactured by Kyoeisha Chemical Co., Ltd.); NK ESTER SA and A-SA (trade names, manufactured by Nakamura Chemical Industry Co., Ltd.); and the like.

Examples of the hydroxyl group-containing monomer that may be used include 2-hydroxyethyl (meth)acrylate, 4-hydroxybutyl (meth)acrylate, 2-hydroxypropyl (meth)acrylate, 2-hydroxybutyl (meth)acrylate, 1-(meth)acryloyl-3-hydroxyadamantane, hydroxymethyl (meth)acrylamide, 2-(hydroxymethyl)-(meth)acrylate, methyl ester of2-(hydroxymethyl)-(meth)acrylate, 3-chloro-2-hydroxypropyl (meth)acrylate, 3,5-dihydroxypentyl (meth)acrylate, 1-hydroxymethyl-4-(meth)acryloylmethyl-cyclohexane, 2-hydroxy-3-phenoxypropyl (meth)acrylate, 1-methyl-2-acryloyloxypropylphthalic acid, 2-acryloyloxyethyl-2-hydroxyethylphthalic acid, 1-methyl-2-acryloyloxyethyl-2-hydroxypropylphthalic acid, 2-acryloyloxyethyl-2-hydroxy-3-chloropropylphthalic acid; ARONIX M-554, M-154, M-555, M-155 and M-158 (trade names, manufactured by Toagosei Co., Ltd.); BLENMER PE-200, PE-350, PP-500, PP-800, PP-1000, 70PEP-350B and 55PET800 (trade names, manufactured by Nippon Oil & Fats Co., Ltd.); and a lactone-modified acrylate having the following structure.

$$CH_2{=}CRCOOCH_2CH_2[OC({=}O)C_5H_{10}]_nOH$$

(wherein R = H or Me, and n = 1 to 5)

Examples of the monomer having an epoxy group that may be used include glycidyl (meth)acrylate, CYCLOMER A and M (trade names, manufactured by Daicel Chemical Industries, Ltd.), and the like.

Examples of the monomer having an isocyanate group that may be used include KARENZ AOI and MOI (trade names, manufactured by Showa Denko K.K.).

Furthermore, the polymer having a cyano group that is used in the synthesis method of (iii) may further contain a third copolymer component.

The monomer having a polymerizable group which is reacted with a polymer having a cyano group in the synthesis method of (iii), may vary with the type of the reactive group in the polymer having a cyano group, but monomers having functional groups of the following combinations may be used.

That is, the combinations include (reactive group of polymer, functional group of monomer) = (carboxyl group, carboxyl group), (carboxyl group, epoxy group), (carboxyl group, isocyanate group), (carboxyl group, halogenated benzyl), (hydroxyl group, carboxyl group), (hydroxyl group, epoxy group), (hydroxyl group, isocyanate group), (hydroxyl group, halogenated benzyl), (isocyanate group, hydroxyl group), (isocyanate group, carboxyl group), (epoxy group, carboxyl group), and the like.

Specifically, the following monomers may be used.

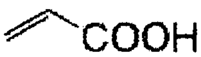
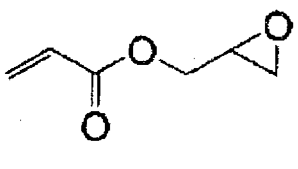
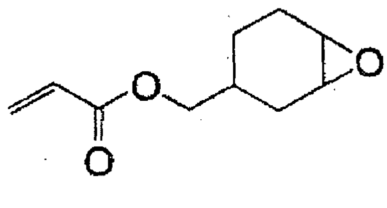

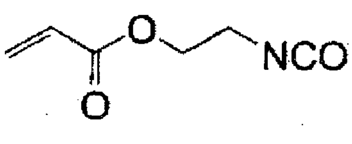
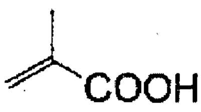
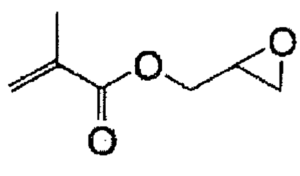

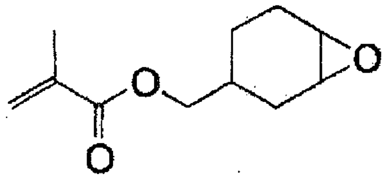

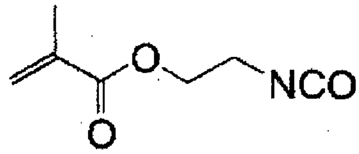

In regard to the cyano group-containing polymerizable polymer according to the invention, when $L^1$ in the formula (1), formula (3) or formula (4) is a divalent organic group having a urethane bond, it is preferable to carry out synthesis by the synthesis method described below (hereinafter, referred to as synthesis method A).

That is, the synthesis method A according to the invention is characterized by forming a urethane bond in $L^1$ by using a polymer having a hydroxyl group in a side chain and a compound having an isocyanate group and a polymerizable group at least in a solvent to add the isocyanate group to the hydroxyl group.

Here, the polymer having a hydroxyl group in a side chain that is used in the synthesis method A, is preferably a copolymer of the monomer used for forming a cyano group-containing unit mentioned in the aspect of (1-2), and a hydroxyl group-containing (meth)acrylate shown below. Examples of the hydroxyl group-containing (meth)acrylate that may be used include 2-hydroxylethyl (meth)acrylate, 4-hydroxybutyl (meth)acrylate, 2-hydroxypropyl (meth)acrylate, 2-hydroxybutyl (meth)acrylate, 1-(meth)acryloyl-3-hydroxy-adamantane, hydroxymethyl (meth)acrylamide, 2-(hydroxymethyl)-(meth)acrylate, methyl ester of 2-(hydroxymethyl)-(meth)acrylate, 3-chloro-2-hydroxypropyl (meth)acrylate, 3,5-dihydroxypentyl (meth)acrylate, 1-hydroxymethyl-4-(meth)acryloylmethyl-cyclohexane, 2-hydroxy-3-phenoxypropyl (meth)acrylate, 1-methyl-2-acryloyloxypropylphthalic acid, 2-acryloyloxyethyl-2-hydroxyethylphthalic acid, 1-methyl-2-acryloyloxyethyl-2-hydroxypropylphthalic acid, 2-acryloyloxyethyl-2-hydroxy-3-chloropropylphthalic acid; ARONIX M-554, M-154, M-555, M-155, M-158 (trade names, manufactured by Toagosei Co., Ltd.); BLENMER PE-200, PE-350, PP-500, PP-800, PP-1000, 70PEP-350B and 55PET800 (trade names, manufactured by Nippon Oil & Fats Co., Ltd.); and a lactone-modified acrylate having the following structure.

$$CH_2=CRCOOCH_2CH_2[OC(=O)C_5H10]_nOH$$

(wherein R = H or Me, n = 1 to 5)

In addition, the polymer having a hydroxyl group in a side chain that is used in the synthesis method A may further contain a third copolymerization component.

Among the polymers having a hydroxyl group in a side chain as described above, use may be made of a polymer synthesized using a raw material from which bifunctional acrylate that is side-produced upon synthesis of the hydroxyl group-containing (meth)acrylate has been removed, as the raw material, from the viewpoint of synthesizing a polymer having a high molecular weight. The method for purification of the hydroxyl group-containing (meth)acrylate is preferably distillation or column purification. More preferably, it is preferable to use a hydroxyl group-containing (meth)acrylate obtained by sequentially going through the following steps (I) to (IV):

(I) Dissolving a mixture containing a hydroxyl group-containing (meth)acrylate and the bifunctional acrylate that is side-produced upon synthesizing the hydroxyl group-containing (meth)acrylate, in water;
(II) Adding a first organic solvent that separates from water, to the obtained aqueous solution, and then separating the layer containing the first organic solvent and the bifunctional acrylate from the aqueous layer;
(III) Dissolving a compound having higher water-solubility than that of the hydroxyl group-containing (meth)acrylate, in the aqueous layer; and
(IV) Extracting the hydroxyl group-containing (meth)acrylate by adding a second organic solvent to the aqueous layer, and then concentrating the extract.

The mixture used in the step of (I) contains a hydroxyl group-containing (meth)acrylate and a bifunctional acrylate, which is an impurity that is side-produced upon synthesizing the hydroxyl group-containing (meth)acrylate, and the mixture corresponds to a common commercially available product of hydroxyl group-containing (meth)acrylate.

In the step of (I), this commercially available product (mixture) is dissolved in water, and thereby an aqueous solution is obtained.

In the step of (II), a first organic solvent that separates from water is added to the aqueous solution obtained in the step of (I). Examples of the first organic solvent used herein include ethyl acetate, diethyl ether, benzene, toluene and the like.

Subsequently, the layer containing this first organic solvent and the bifunctional acrylate (oil layer) is separated from the aqueous solution (aqueous layer).

In the step of (III), a compound having higher water-solubility than that of the hydroxyl group-containing

(meth)acrylate is dissolved in the aqueous layer separated from the oil layer in the step of (II).

As the compound having higher water-solubility than that of the hydroxyl group-containing (meth)acrylate used herein, inorganic salts, such as alkali metal salts such as sodium chloride and potassium chloride, and alkaline earth metal salts such as magnesium sulfate and calcium sulfate, are used.

In the step of (IV), the hydroxyl group-containing (meth)acrylate is extracted by adding a second organic solvent to the aqueous layer, and then the extract is concentrated.

Examples of the second organic solvent used herein include ethyl acetate, diethyl ether, benzene, toluene, and the like. This second organic solvent may be identical with the first organic solvent mentioned above, or may be different from the first organic solvent.

Drying over anhydrous magnesium sulfate, elimination by distillation under reduced pressure and the like are used for the concentration in the step of (IV).

The isolation product containing the hydroxyl group-containing (meth)acrylate obtained by sequentially going through the steps of (I) to (IV), preferably contains the bifunctional acrylate in an amount in the range of 0.1% by mass or less based on the total mass of the isolation product. That is, by going through the steps of (I) to (IV), the impurity bifunctional acrylate is removed from the mixture, and thereby the hydroxyl group-containing (meth)acrylate is purified.

A more preferred range of the content of the bifunctional acrylate is 0.05% by mass or less based on the total mass of the isolation product, and a smaller content is better.

When the hydroxyl group-containing (meth)acrylate thus purified is used, it is difficult for the impurity bifunctional acrylate to exert influence on the polymerization reaction. Thus, a nitrile group-containing polymerizable polymer having a weight average molecular weight of 20000 or greater may be synthesized.

As the hydroxyl group-containing (meth)acrylate used in the step of (I), use may be made of those mentioned as the hydroxyl group-containing (meth)acrylate used upon synthesizing the polymer having a hydroxyl group in a side chain, which is used in the synthesis method A described above. Among them, a monomer having a primary hydroxyl group is preferred from the viewpoint of reactivity to isocyanate, and furthermore, a hydroxyl group-containing (meth)acrylate having a molecular weight of 100 to 250 is preferred from the viewpoint of increasing the ratio of the polymerizable group per unit weight of the polymer.

Examples of the compound having an isocyanate group and a polymerizable group, which is used in the synthesis method A, include 2-acryloyloxyethyl isocyanate (trade name: KARENZ AOI, manufactured by Showa Denko K.K.), 2-methacryloxy isocyanate (trade name: KARENZ MOI, manufactured by Showa Denko K.K.), and the like.

The solvent used in the synthesis method A is preferably a solvent having an SP value (calculated by the Okitsu method) of 20 to 23 $MPa^{1/2}$, and specific examples include ethylene glycol diacetate, diethylene glycol diacetate, propylene glycol diacetate, methyl acetoacetate, ethyl acetoacetate, 1,2,3-triacetoxypropane, cyclohexanone, 2-(1-cyclohexenyl)cyclohexanone, propionitrile, N-methylpyrrolidone, dimethylacetamide, acetylacetone, acetophenone, triacetin, 1,4-dioxane, dimethyl carbonate, and the like.

Among them, the solvent is more preferably an ester-based solvent, from the viewpoint of synthesizing a high molecular weight product, and particularly, diacetate-based solvents such as ethylene glycol diacetate and diethylene glycol diacetate, and dimethyl carbonate are more preferred.

Here, the SP value of a solvent according to the invention is a value calculated by the Okitsu method (Okitsu, Toshinao, "Journal of the Adhesion Society of Japan," 29(3) (1993)). Specifically, the SP value is a value calculated by the following formula. Here, $\Delta F$ is a value described in the literature.

$$\text{SP value } (\delta) = \Sigma\Delta F \text{ (Molar Attraction Constants)/V (molar volume)}$$

The cyano group-containing polymerizable polymer according to the invention that is synthesized as described above, is such that the proportions of the polymerizable group-containing unit and the cyano group-containing unit based on the total amount of the copolymerization components are preferably in the following range.

That is, the polymerizable group-containing unit is preferably contained at a proportion of 5 to 50 mol%, and more preferably 5 to 40 mol%, based on the total amount of the copolymerization components. When the proportion is 5 mol% or less, reactivity (curability, polymerizability) is deteriorated. When the proportion is 50 mol% or more, the copolymer is prone to undergo gelation upon synthesis, and it is difficult to synthesize the copolymer.

The cyano group-containing unit is preferably contained at a proportion of 5 to 95 mol%, and more preferably 10 to 95 mol%, based on the total amount of the copolymerization components, from the viewpoint of absorbability to the plating catalyst.

Furthermore, the cyano group-containing polymerizable polymer according to the invention may further contain another unit in addition to the cyano group-containing unit and the polymerizable group-containing unit. Any monomer may be used as a monomer which is used for forming this other unit, as long as the monomer does not impair the effects

of the invention.

The monomer used for forming the other unit may be, specifically, a monomer capable of forming a main chain skeleton such as an acrylic resin skeleton, a styrene resin skeleton, a phenolic resin (phenol-formaldehyde resin) skeleton, a melamine resin (a polycondensation product of melamine and formaldehyde) skeleton, a urea resin (a polycondensation product of urea and formaldehyde) skeleton, a polyester resin skeleton, a polyurethane skeleton, a polyimide skeleton, a polyolefin skeleton, a polycycloolefin skeleton, a polystyrene skeleton, a polyacryl skeleton, an ABS resin (a polymer of acrylonitrile, butadiene and styrene) skeleton, a polyamide skeleton, a polyacetal skeleton, a polycarbonate skeleton, a polyphenylene ether skeleton, a polyphenylene sulfide skeleton, a polysulfone skeleton, a polyether sulfone skeleton, a polyallylate skeleton, a polyether ether ketone skeleton or a polyamideimide skeleton.

These main chain skeletons may also be the main chain skeleton of the cyano group-containing unit or the polymerizable group-containing unit.

However, when a polymerizable group is introduced into the polymer through a reaction as described above, if it is difficult to introduce 100% of the polymerizable group, a small amount of the reactive moiety remains behind, so that this may become a third unit.

Specifically, in the case of forming the polymer main chain by radical polymerization, unsubstituted (meth)acrylic acid esters such as ethyl (meth)acrylate, butyl (meth)acrylate, hexyl (meth)acrylate, 2-ethylhexyl (meth)acrylate, cyclohexyl (meth)acrylate, benzyl (meth)acrylate and stearyl (meth)acrylate; halogen-substituted (meth)acrylic acid esters such as 2,2,2-trifluoroethyl (meth)acrylate, 3,3,3-trifluoropropyl (meth)acrylate and 2-chloroethyl (meth)acrylate; ammonium group-substituted (meth)acrylic acid esters such as 2-(meth)acryloyloxyethyltrimethylammonium chloride; (meth)acrylamides such as butyl (meth)acrylamide, isopropyl (meth)acrylamide, octyl (meth)acrylamide and dimethyl (meth)acrylamide; styrenes such as styrene, vinylbenzoic acid and p-vinylbenzylammonium chloride; vinyl compounds such as N-vinylcarbazole, vinyl acetate, N-vinylacetamide and N-vinylcaprolactam; as well as dimethylaminoethyl (meth)acrylate, diethylaminoethyl (meth)acrylate, 2-ethylthioethyl (meth)acrylate, (meth)acrylic acid, 2-hydroxyethyl (meth)acrylate, and the like may be used.

Furthermore, use may also be made of macromonomers obtained by using the monomers described above.

In the case of forming the polymer main chain by cationic polymerization, vinyl ethers such as ethyl vinyl ether, butyl vinyl ether, isobutyl vinyl ether, cyclohexyl vinyl ether, ethylene glycol vinyl ether, di(ethylene glycol) vinyl ether, 1,4-butanediol vinyl ether, 2-chloroethyl vinyl ether, 2-ethylhexyl vinyl ether, vinyl acetate, 2-vinyloxytetrahydropyrane, vinyl benzoate and vinyl butyrate; styrenes such as styrene, p-chlorostyrene and p-methoxystyrene; and terminal ethylenes such as allyl alcohol and 4-hydroxy-1-butene may be used.

The weight average molecular weight of the cyano group-containing polymerizable polymer according to the invention is preferably from 1000 to 700,000, and more preferably from 2000 to 200,000. Particularly, from the viewpoint of polymerization sensitivity, the weight average molecular weight of the cyano group-containing polymerizable polymer according to the invention is preferably 20,000 or greater.

In regard to the degree of polymerization of the cyano group-containing polymerizable polymer according to the invention, it is preferable to use a polymer having 10-mers or more, and more preferably 20-mers or more. Furthermore, a polymer having 7000-mers or fewer, more preferably 3000-mers or fewer, even more preferably 2000-mers or fewer, and particularly preferably 1000-mers or fewer.

Preferable ranges for the molecular weight and degree of polymerization described herein are suitable ranges also for the polymer having an interactable group and a polymerizable group, other than the cyano group-containing polymerizable polymer used in the invention.

Specific examples of the cyano group-containing polymerizable polymer according to the invention will be presented below, but the invention is not intended to be limited to these.

In addition, the weight average molecular weights of these specific examples are all in the range of 3000 to 100,000.

Polymers obtained by aspect (1-1)

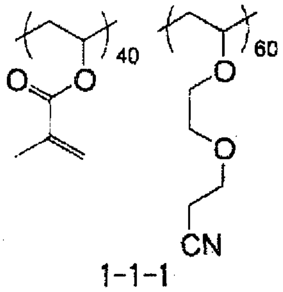

1-1-1

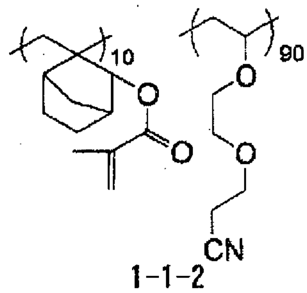

1-1-2

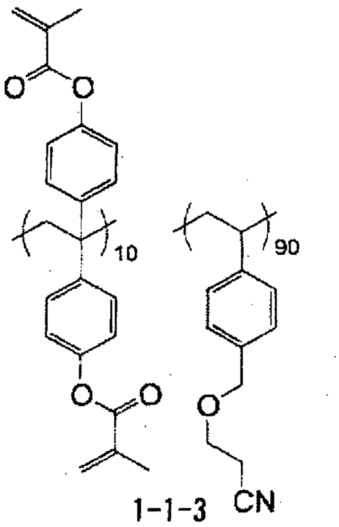

1-1-3

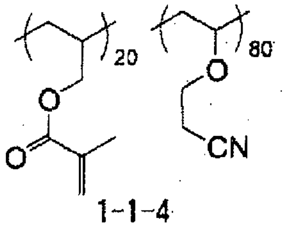

1-1-4

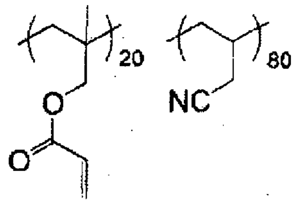

1-1-5

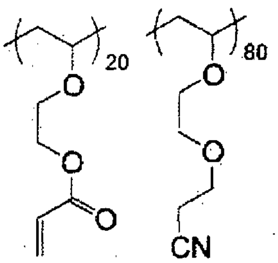

1-1-6

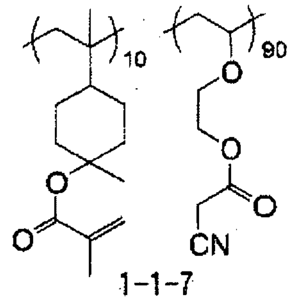

1-1-7

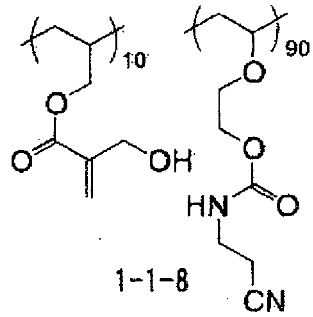

1-1-8

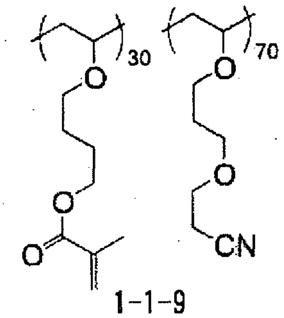

1-1-9

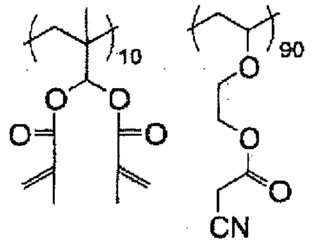

1-1-10

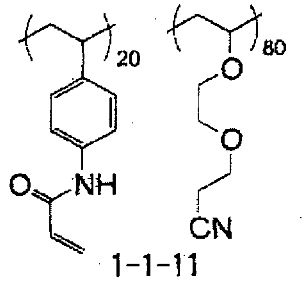

1-1-11

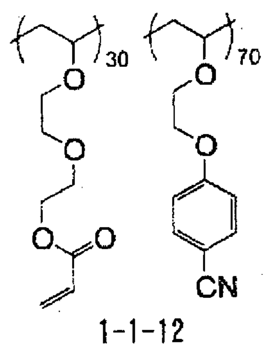

1-1-12

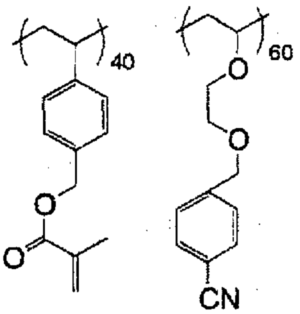

1-1-13

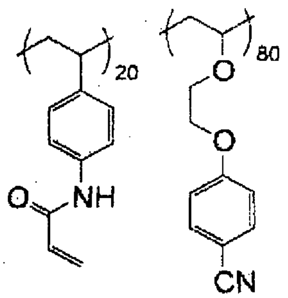

1-1-14

Polymers obtained by aspect (1-2)

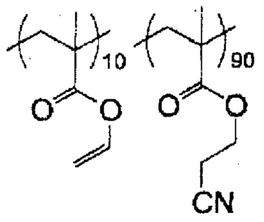

1-2-1

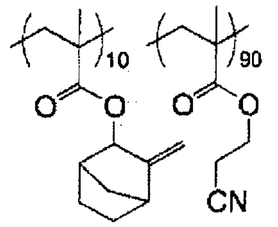

1-2-2

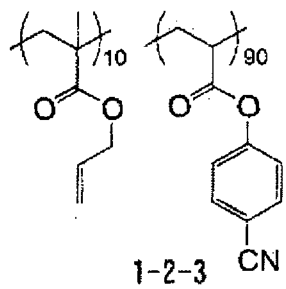

1-2-3

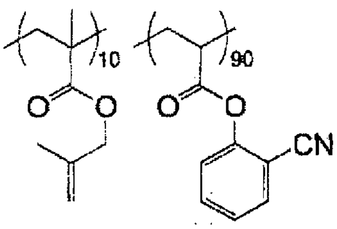

1-2-4

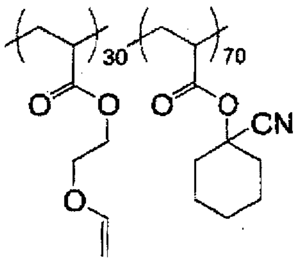

1-2-5

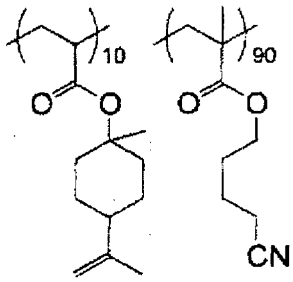

1-2-6

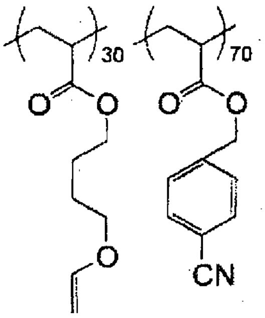

1-2-7

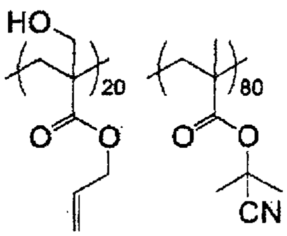

1-2-8

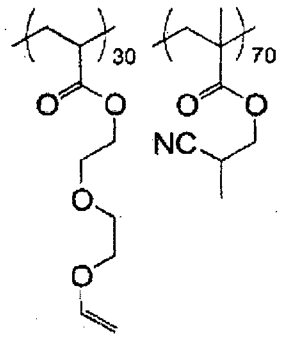

1-2-9

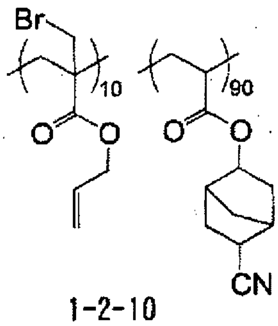

1-2-10

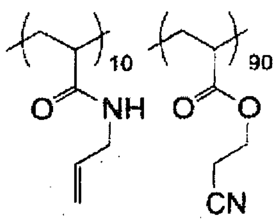

1-2-11

Polymers obtained by aspect (2-1)

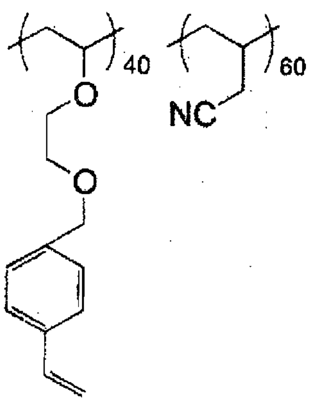

2-1-1

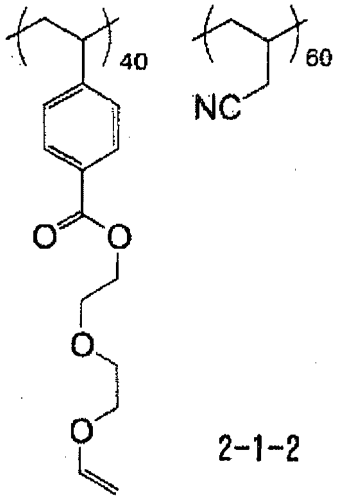

2-1-2

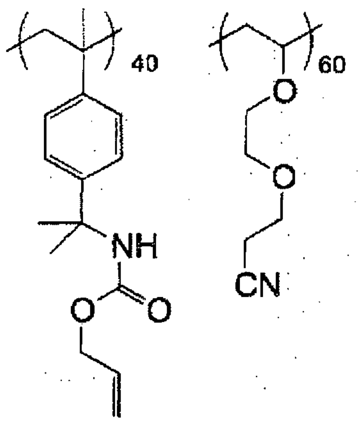

2-1-3

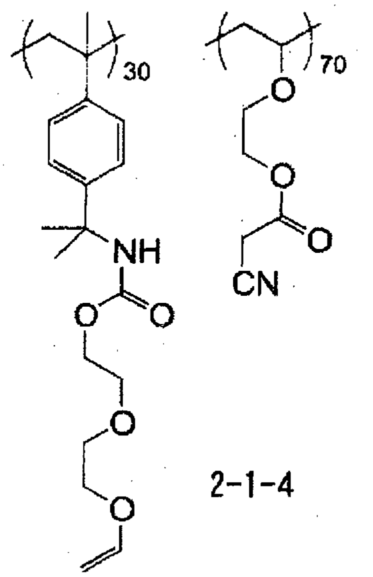

2-1-4

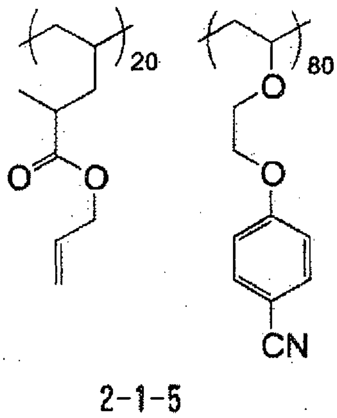

2-1-5

Polymers obtained by aspect (2-2)

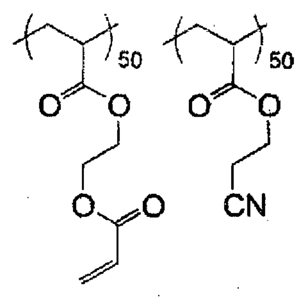

2-2-1

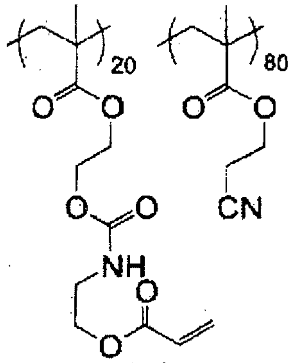

2-2-2

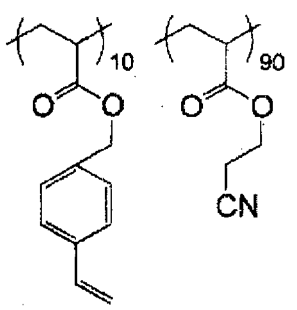

2-2-3

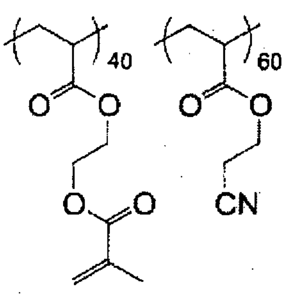

2-2-4

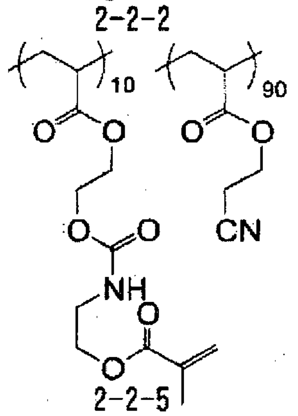

2-2-5

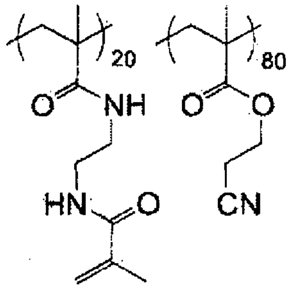

2-2-6

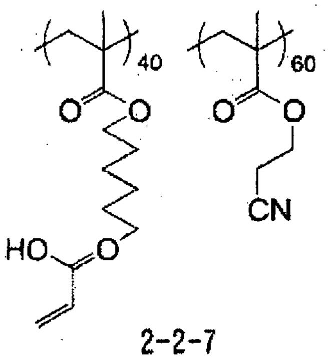

2-2-7

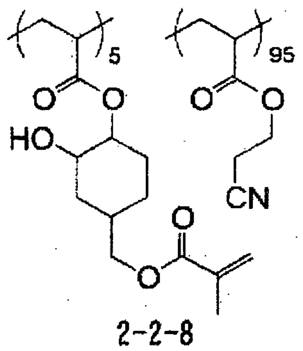

2-2-8

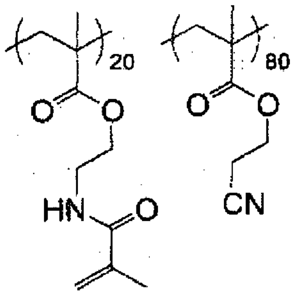

2-2-9

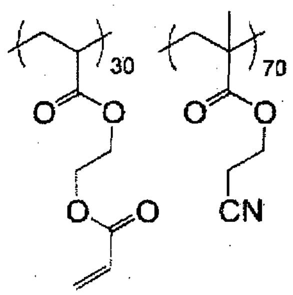

2-2-10

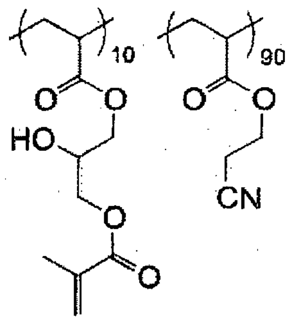

2-2-11

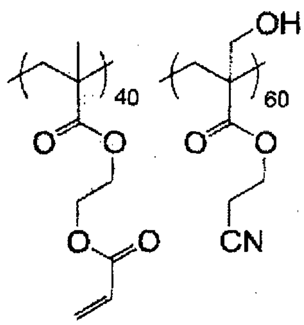

2-2-12

Polymers obtained by aspect (2-2)

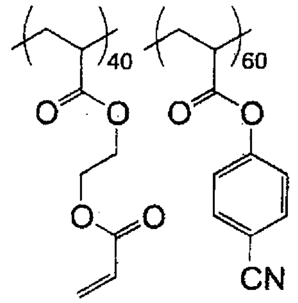

2-2-13

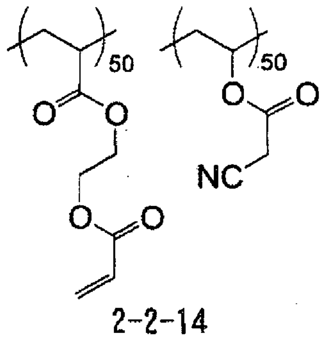

2-2-14

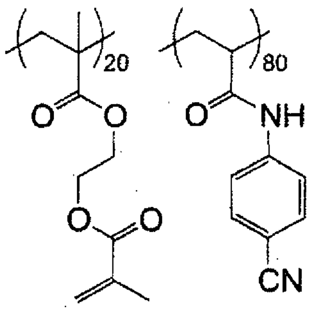

2-2-15

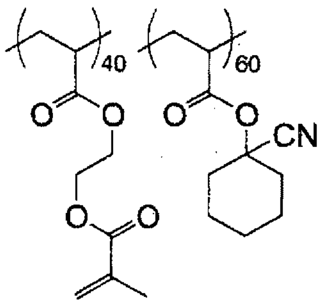

2-2-16

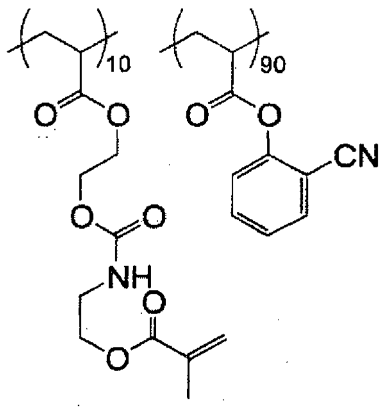

2-2-17

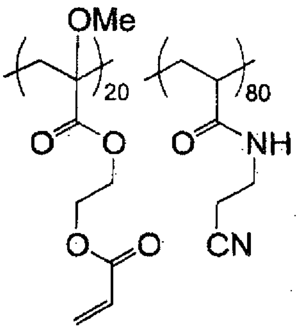

2-2-18

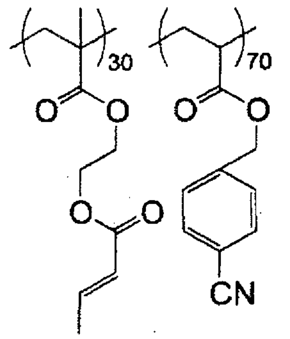

2-2-19

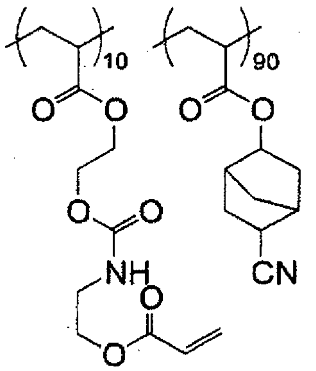

2-2-20

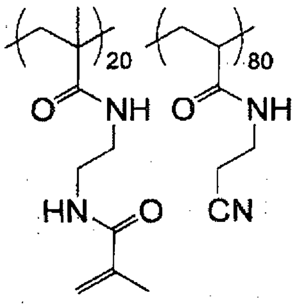

2-2-21

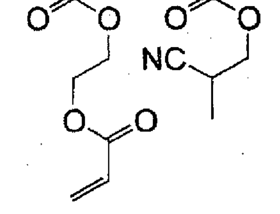

2-2-22

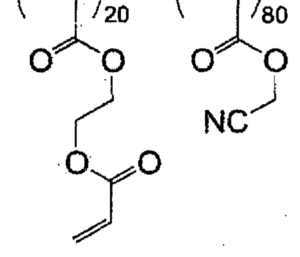

2-2-23

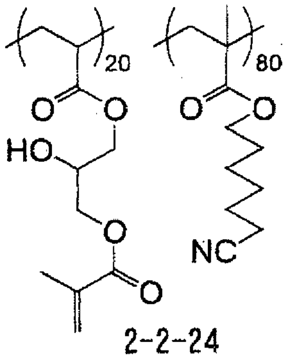

2-2-24

Polymers obtained by aspect (2-2)

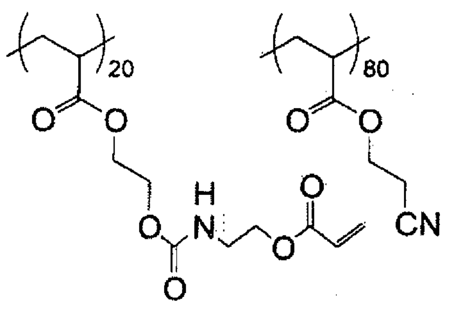

2-2-25

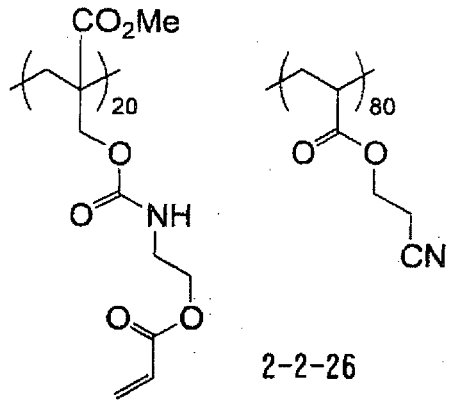

2-2-26

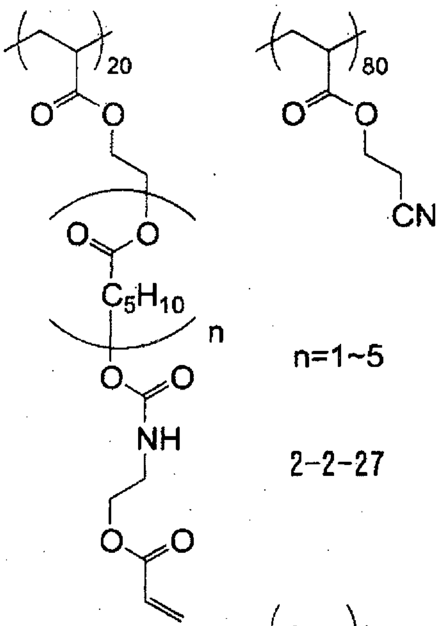

n=1~5

2-2-27

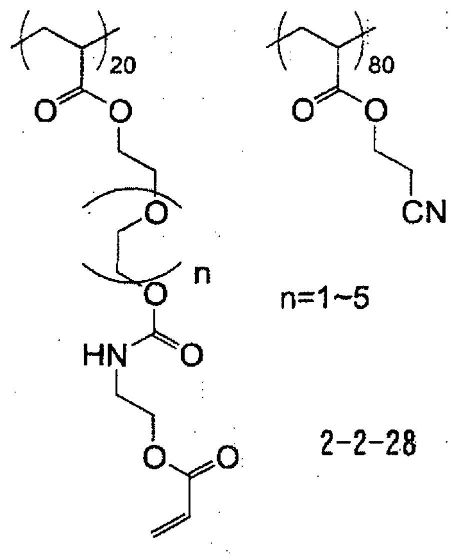

n=1~5

2-2-28

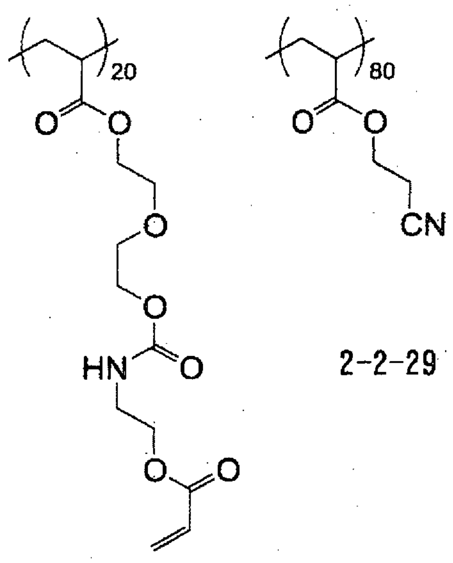

2-2-29

Polymers obtained by aspect (2-2)

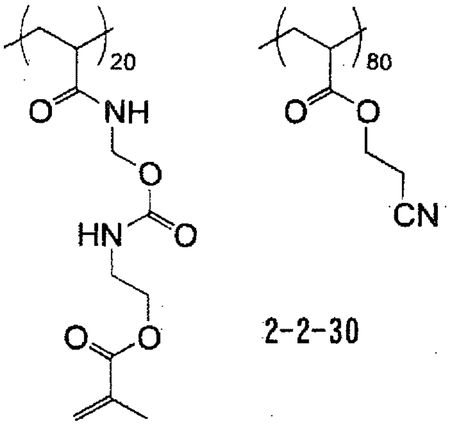

2-2-30

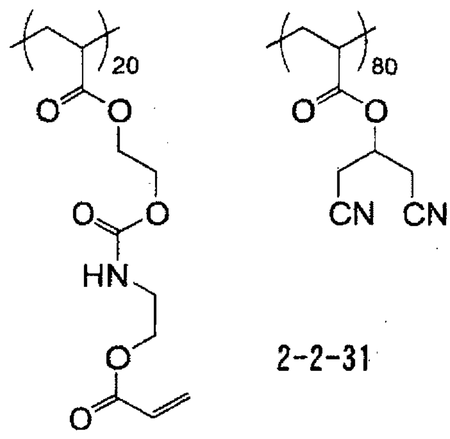

2-2-31

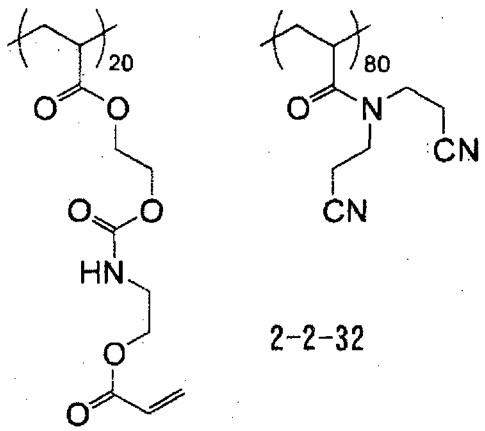

2-2-32

Here, for example, compound 2-2-11 of the specific examples may be synthesized by dissolving acrylic acid and 2-cyanoethyl acrylate in, for example, N-methylpyrrolidone, performing radical polymerization using, for example, azoisobutyronitrile (AIBN) as a polymerization initiator, and then subjecting the resulting polymer to an addition reaction with glycidyl methacrylate using a catalyst such as benzyltriethylammonium chloride, in a state of having a polymerization inhibitor such as tertiary-butylhydroquinone.

In addition, for example, compound 2-2-19 of the specific examples may be synthesized by dissolving the monomer shown below and p-cyanobenzyl acrylate in a solvent such as N,N-dimethylacrylamide, performing radical polymerization using a polymerization initiator such as dimethyl azoisobutyrate, and then dehydrochlorinating the resulting polymer using a base such as triethylamine.

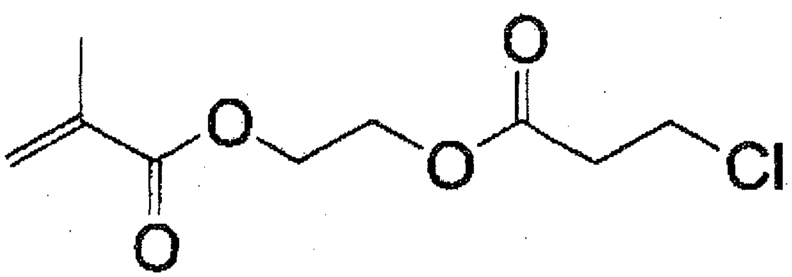

The compound having an interactable group and a polymerizable group according to the invention, such as the cyano group-containing polymerizable polymer, may also have a polar group in addition to the polymerizable group and interactable group.

When the compound has a polar group, in the case of providing, for example, a protective layer after a plating film has been formed by the step (b) that will be described later, the adhesive power at the contact area of the resin layer and the protective layer may be enhanced.

In order to form a resin layer as described above, it is preferable to use a liquid composition containing a

compound having an interactable group and a polymerizable group, such as a polymer having an interactable group and a polymerizable group, that is, a composition containing a compound having an interactable group and a polymerizable group, and a solvent capable of dissolving the compound.

The content of the compound having an interactable group and a polymerizable group in the composition is preferably 2% by mass to 50% by mass, based on the whole composition.

The solvent used in the composition is not particularly limited, if the compound having an interactable group and a polymerizable group, which is a main component of the composition, can be dissolved therein. The solvent may be further added with a surfactant.

Examples of the solvent that may be used include alcohol-based solvents such as methanol, ethanol, propanol, ethylene glycol, glycerin and propylene glycol monomethyl ether; acids such as acetic acid; ketone-based solvents such as acetone, methyl ethyl ketone and cyclohexanone; amide-based solvents such as formamide, dimethylacetamide and N-methylpyrrolidone; nitrile-based solvents such as acetonitrile and propylonitrile; ester-based solvents such as methyl acetate and ethyl acetate; carbonate-based solvents such as dimethyl carbonate and diethyl carbonate; and the like.

Among these, in the case of a composition making use of a cyano group-containing polymerizable polymer, amide-based, ketone-based, nitrile-based solvents and carbonate-based solvents are preferred, and specifically, acetone, dimethylacetamide, methyl ethyl ketone, cyclohexanone, acetonitrile, propionitrile, N-methylpyrrolidone and dimethyl carbonate are preferred.

Furthermore, in the case of coating a composition containing a cyano group-containing polymerizable polymer, a solvent having a boiling point of 50 to 150°C is preferred from the viewpoint of easy handlability. These solvents may be used singly, or may be used as mixtures.

According to the invention, when the composition containing a compound having an interactable group and a polymerizable group is coated on a substrate or a polymerization initiating layer, a solvent may be selected such that a solvent absorption ratio of the substrate or the polymerization initiating layer of 5 to 25% is obtained. This solvent absorption ratio may be determined from the changes in mass, which is obtained by submerging the substrate or a base material having the polymerization initiating layer formed thereon in the solvent, and pulling it out after 1000 minutes.

In the case of coating the composition containing a compound having an interactable group and a polymerizable group on a substrate or a polymerization initiating layer, a solvent may also be selected such that a swelling ratio of the substrate or the polymerization initiating layer of 10 to 45% is obtained. This swelling ratio may be determined from the changes in thickness, which is obtained by submerging the substrate or a base material having the polymerization initiating layer in the solvent, and pulling it out after 1000 minutes.

The surfactant that may be added to the solvent as necessary may be any solvent that is dissolved in the solvent, and examples of such a surfactant include anionic surfactants such as sodium n-dodecyl benzenesulfonate; cationic surfactants such as n-dodecyltrimethylammonium chloride; nonionic surfactants such as polyoxyethylene nonyl phenol ether (commercially available products include, for example, EMULGEN 910 manufactured by Kao Corp.; and the like), polyoxyethylene sorbitan monolaurate (commercially available products include, for example, "TWEEN 20 (trade name)" and the like), and polyoxyethylene lauryl ether; and the like.

Furthermore, a plasticizer may also be added if necessary. For the plasticizer that may be used, common plasticizers may be used, and phthalic acid esters (dimethyl ester, diethyl ester, dibutyl ester, di-2-ethylhexyl ester , di-normal-octyl ester, diisononyl ester, dinonyl ester, diisodecyl ester, butyl benzyl ester), adipic acid esters (dioctyl ester, diisononyl ester), dioctyl azelate, sebacic acid esters (dibutyl ester, dioctyl ester), tricresyl phosphate, tributyl acetylcitrate, epoxidated soybean oil, trioctyl trimellitate, chlorinated paraffins, or high boiling point solvents such as dimethylacetamide and N-methylpyrrolidone may also be used.

The composition containing the compound having an interactable group and a polymerizable group may also be added with a polymerization inhibitor as necessary. Examples of the polymerization inhibitor that may be used include hydroquinones such as hydroquinone, di-tertiary-butylhydroquinone and 2,5-bis(1,1,3,3-tetramethylbutyl)hydroquinone; phenols such as p-methoxyphenol and phenol; benzoquinones; free radicals such as TEMPO (2,2,6,6-tetramethyl-1-piperidinyloxy free radical) and 4-hydroxy TEMPO; phenothiazines; nitrosoamines such as N-nitrosophenylhydroxyamine and aluminum salt thereof; and catechols.

The composition containing the compound having an interactable group and a polymerizable group may contain, if necessary, a curing agent and/or a curing accelerating agent so as to allow curing of the polymerization initiating layer to proceed. Examples of the curing agent and/or curing accelerating agent in the case where an epoxy compound is contained in the polymerization initiating layer, include, as for the polyaddition type, aliphatic polyamine, alicyclic polyamine, aromatic polyamine, polyamide, acid anhydride, phenol, phenol novolac, polymercaptan, a compound having two or more active hydrogen atoms, and the like; and as for the catalyst type, aliphatic tertiary-amine, aromatic tertiary-amine, an imidazole compound, a Lewis acid complex, and the like.

Furthermore, examples of such an agent that initiates curing under the action of heat, light, moisture, pressure, acid, base or the like, include diethylenetriamine, triethylenetetramine, tetraethylenepentamine, diethylaminopropylamine, polyamidoamine, menthenediamine, isophoronediamine, N-aminoethylpiperazine, 3,9-bis(3-aminopropyl)-2,4,8,10-tetraoxyspiro(5,5)undecane adduct, bis(4-amino-3-methylcyclohexyl)methane, bis(4-aminocyclohexyl)methane, m-xylenediamine, diaminodiphenylmethane, m-phenylenediamine, diaminodiphenylsulfone, dicyandiamide, adipic acid dihydrazide, phthalic anhydride, tetrahydrophthalic anhydride, hexahydrophthalic anhydride, methyltetrahydrophthalic anhydride, methylhexahydrophthalic anhydride, methylnadic anhydride, dodecylsuccinic anhydride, chlorendic anhydride, pyromellitic anhydride, benzophenone tetracarboxylic acid anhydride, ethylene glycol bis(anhydrotrimate), methylcyclohexene tetracarboxylic acid anhydride, trimellitic anhydride, polyazelaic acid anhydride, phenol novolac, xylene novolac, bis A novolac, triphenylmethane novolac, biphenyl novolac, dicyclopentadiene phenol novolac, terpene phenol novolac, polymercaptan, polysulfide, 2,4,6-tris(dimethylaminomethyl)phenol, 2,4,6-tris(dimethylaminomethyl)phenol-tri-2-ethylhexanoic acid salt, benzyldimethylamine, 2-(dimethylaminomethyl)phenol 2-methylimidazole, 2-ethyl-4-methylimidazole 2-undecylimidazole, 2-heptadecylimidazole, 2-phenylimidazole, 1-benzyl-2-methylimidazole, 1-cyanoethyl-2-methylimidazole, 2,4-diamino-6-(2-methylimidazolyl-(1))-ethyl S-triazine, a $BF_3$-monoethylamine complex, a Lewis acid complex, an organic acid hydrazide, diaminomaleonitrile, a melamine derivative, an imidazole derivative, a polyamine salt, an amineimide compound, an aromatic diazonium salt, a diallyliodonium salt, a triallylsulfonium salt, a triallylselenium salt, a ketimine compound, and the like.

These curing agents and/or effect accelerating agents are preferably added in an amount of about 0 to 50% by mass of the non-volatile components remaining after the solvent has been removed, from the viewpoints of the coatability of the solution, adhesiveness to the substrate or the plating film, and the like. The curing agent and/or curing accelerating agent may be added to the polymerization initiating layer, and in that case, it is preferable to fulfill the above range with the amount of the agent(s) added to the polymerization initiating layer and the total amount of the agent(s) added to the resin layer.

Furthermore, a rubber component (for example, CTBN), a flame retardant (for example, a phosphorus-based flame retardant), a diluent or a thixotropic agent, a pigment, a defoaming agent, a leveling agent, a coupling agent and the like may also be added. These additives may be added to the polymerization initiating layer according to necessity.

When a composition prepared by appropriately mixing such a compound having an interactable group and a polymerizable group with various additives is used, properties of the formed resin layer, for example, coefficient of thermal expansion, glass transition temperature, Young's modulus, Poisson ratio, rupture stress, yield stress, thermal degradation temperature and the like may be optimally obtained. Particularly, higher rupture stress, yield stress and thermal degradation temperature are more preferable.

The thermal durability of the obtained resin layer may be measured by a temperature cycle test, a heat time test, a reflow test or the like, and for example, in regard to thermal degradation, the resin layer may be evaluated to have sufficient thermal durability, if the mass reduction occurring upon exposure to an environment at 200°C for one hour is 20% or less.

When the composition containing the compound having an interactable group an a polymerizable group is contacted with a substrate, the amount of coating thereof is preferably 0.1 to 10 g/m$^2$, and particularly preferable 0.5 to 5 g/m$^2$, in terms of the solids content, from the viewpoint of the properties for the formation of sufficient interaction between the composition and the plating catalyst or a precursor thereof.

When a layer containing a compound having an interactable group and a polymerizable group is formed by applying and drying the composition containing the compound having an interactable group and a polymerizable group on a substrate, the applied composition may be left to stand at 20 to 40°C for 0.5 to 2 hours between the application and drying, to thereby remove any remaining solvent.

(Application of energy)

The method of applying energy to the surface of the substrate may utilize, for example, irradiation of radiation such as heating or exposure. For example, photo-irradiation using a UV lamp, visible light or the like; heating with a hot plate; and the like may be made possible. Examples of the light source include a mercury lamp, a metal halide lamp, a xenon lamp, a chemical lamp, a carbon arc lamp, and the like. Examples of radiation include electron beams, X-rays, ion beams, far-infrared rays, and the like. Furthermore, g-rays, i-rays, deep-UV light, or high-density energy beams (laser beams) may also be used.

Specific suitable aspects that are generally used include direct imagewise recording by a thermal recording head or the like, scan exposure by an infrared laser, high-illuminance flash exposure by a xenon discharge lamp or the like, infrared lamp exposure, and the like.

The time required for energy application may vary with the amount of production of the intended graft polymer and the light source, but the time is usually between 10 seconds and 5 hours.

When the application of energy is carried out by exposure, the exposure power is preferably in the range of 10 mJ/cm$^2$ to 5000 mJ/cm$^2$, and more preferably in the range of 50 mJ/cm$^2$ to 3000 mJ/cm$^2$, so as to carry out graft polymerization easily, and to suppress degradation of the produced graft polymer.

Furthermore, if a polymer having an average molecular weight of 20,000 or more and a degree of polymerization

of 200-mers or more is used as the compound having an interactable group and a polymerizable group, graft polymerization may be easily carried out with low-energy exposure, and therefore, degradation of the produced graft polymer may be further suppressed.

As described above, a resin layer formed from a resin chemically bound to the surface of the substrate is formed.

If the obtained resin layer is such that, for example, the progress of degradation at the polymerizable group site is 50% or less after the resin layer has been added to an alkaline solution at pH 12 and stirred for one hour, the resin layer may be subjected to washing with a highly alkaline solution.

When the resin layer formed from a resin chemically bound to the surface of the substrate has been formed as described above, the following method may be used to make the amount of presence of the plating catalyst or a precursor thereof to satisfy the requirement 1.

A first method may be, for example, a method of applying a plating catalyst liquid containing a catalytic element (plating catalyst or a precursor thereof) and an organic solvent, onto the resin layer formed from a resin chemically bound to the surface of the substrate.

When this plating catalyst liquid is applied onto the resin layer, if an interactable group is present at the surface of the resin layer, the catalytic element attaches (adsorbs) to the interactable group.

The catalytic element constituting the plating catalyst liquid according to the invention may be an element that serves as an active core or functions as an electrode, at the time of plating carried out in the step (b) that will be described later.

The catalytic element is not particularly limited as long as it is capable of serving as an active core or functioning as an electrode, and examples include Pd, Ag, Cu, Ni, Al, Fe, Co and the like. Among them, an element capable of polydentate coordination is preferred, and particularly from the viewpoints of the number of types of the functional group capable of coordination and the extent of the catalytic capacity, Pd is particularly preferred.

The catalytic element in the plating catalyst liquid according to the invention exists in the form of ions, in the form of metal microparticles, or in the form of colloid (metal colloid).

The metal colloid, which is the form of existence of the catalytic element in the plating catalyst liquid, may be produced generally by reducing the metal ions in a solution containing a charged surfactant or a charged protective agent. The charge of the metal colloid may be regulated by means of the surfactant or protective agent used herein.

A plating catalyst liquid having the catalytic element present in the form of ions, may be produced by using a metal salt. The metal salt being used is not particularly limited if the salt dissolves in an appropriate solvent and dissociates into metal ions and a base (anions), and examples include $M(NO_3)_n$, $MCl_n$, $M_{2/n}(SO_4)$, $M_{3/n}(PO_4)$ (wherein M represents an n-valent metal atom), and the like.

According to the invention, examples of the organic solvent used in the plating catalyst liquid include acetone, MEK, methanol, ethanol, propanol, acetonitrile, propionitrile, and the like. Among them, acetone and methanol are preferred, and acetone is particularly preferred, in view of solubility, and volatility at the time of drying.

As the liquid component that constitutes the plating catalyst liquid according to the invention, water (distilled water) may be used in addition to the organic solvents mentioned above.

The content ratio of water and the organic solvent in the plating catalyst liquid is preferably in the range of water:organic solvent = 0:100 to 95:5, and particularly, from the viewpoint that the rate of the catalytic element attaches to the resin layer is increased, it is desirable to have more of the organic solvent with respect to water. Specifically, the ratio of water:organic solvent is more preferably in the range of 0:100 to 20:80, and even more preferably in the range of 0:100 to 40:60.

Concerning the method of applying the plating catalyst liquid onto the resin layer, the plating catalyst liquid may be coated on the surface of the resin layer, or a substrate having the resin layer may be immersed in the plating catalyst liquid.

In the case of using a surface graft polymerization method upon obtaining the resin layer formed from a resin chemically bound to the surface of the substrate, a composition containing a compound having an interactable group and a polymerizable group is contacted on top of the substrate, but a method of adding a catalytic element to this composition may also be used. When a composition containing a catalytic element and a compound having an interactable group and a polymerizable group is contacted on top of the substrate, and a surface graft polymerization method is applied, there may be formed a resin layer containing a catalytic element and a polymer which has an interactable group and is directly chemically bound to the base material.

Furthermore, if the substrate is a resin film, and resin layers have been formed on both surfaces of the resin film, it is preferable to use the immersion method as described above, in order to simultaneously bring the plating catalyst liquid to contact with both surfaces of the resin layer.

When the plating catalyst liquid is contacted with the resin layer as described above, if an interactable group is present at the surface of the resin layer, the catalytic element may be adsorbed to the interactable group by utilizing interaction based on the intermolecular force such as van der Waals force, or interaction based on coordinate bonding through lone pair electrons.

From the viewpoint of sufficiently achieving such adsorption, the concentration of the catalytic element in the plating catalyst liquid is preferably in the range of 0.001 to 50% by mass, and more preferably in the range of 0.005 to 30% by mass. The contact time is preferably about 30 seconds to 24 hours, and more preferably about 1 minute to 1 hour.

(Other embodiments for formation of resin layer)

According to the invention, the resin layer may also be formed by preparing a coating liquid containing the plating catalyst or a precursor thereof at a predetermined concentration and a resin, and applying and drying this coating liquid on a substrate.
The resin used in this coating liquid is not particularly limited, but it is preferable that the resin have a functional group capable of forming interaction with the plating catalyst or a precursor thereof, for example, a cyano group, a cyanate group, an imide group, a pyridine group, a tertiary amino group or a pyrrolidone group.
Examples of the plating catalyst or a precursor thereof used in the coating liquid may be the same as those used in the plating catalyst liquid described above. The content of this plating catalyst or a precursor thereof may be an amount which would satisfy the requirement 1.
Furthermore, examples of the solvent used for preparing the coating liquid include acetone, MEK, acetonitrile, propionitrile, methanol, ethanol, propanol and the like.
The amount of coating of the coating liquid is not particularly limited, but the amount is preferably 0.2 $g/m^2$ to 10 $g/m^2$, and more preferably 0.5 $g/m^2$ to 5 $g/m^2$, in terms of the amount of coating in solids.
Furthermore, the coating method is not limited, but examples include a gravure printing method, a spin coating method, a dip coating method, an inkjet method and the like.
As such, a resin layer containing a plating catalyst or a precursor thereof, which satisfies the requirement 1, is formed in the step (a).
Here, the thickness of the resin layer formed may be 25 nm or greater to satisfy the requirement 1, but from the viewpoint of maintaining the film strength and the mechanical strength required of a composite material, the thickness is preferably in the range of 0.1 μm to 10 μm, and more preferably in the range of 0.2 μm to 5 μm.

[Step (b)]

In the step (b), the resin layer containing a plating catalyst or a precursor thereof formed in the step (a) described above, is subjected to plating. Thereby, a plating film is formed inside and on top of the resin layer. The formed plating film has excellent electrical conductivity and adhesiveness.
The types of the plating performed in the present step include electroless plating, electroplating, and the like, and the type of plating may be selected based on the function of the plating catalyst or a precursor thereof within the resin layer formed in the step (a).
That is, in the present step, the resin layer containing a plating catalyst or a precursor thereof may be subjected to electroplating, or may be subjected to electroless plating.
Among them, according to the invention, it is preferable to carry out electroless plating, in view of the properties for the formation of a hybrid structure that is exhibited in the resin layer, and an enhancement of adhesiveness. According to a more preferred aspect, electroplating is further carried out after the electroless plating, so as to obtain a plating film of desired thickness.
Plating that is suitably carried out in the present step will be explained below.

(Electroless plating)

Electroless plating means an operation of precipitating metal through a chemical reaction, using a solution having dissolved therein the ions of a metal that is wished to be precipitated as plating.
Electroless plating in the present step is carried out by, for example, washing the substrate having a resin layer as obtained in the step (a), with water to remove any excess catalytic element (metal), and then submerging the substrate into an electroless plating bath. A generally known electroless plating bath may be used as the electroless plating bath used herein.
When the catalytic element is contained in the resin layer in the form of metal ions, an electroless plating bath containing a reducing agent is used. By using such an electroless plating bath, the metal ions are reduced, and subsequently, electroless plating is carried out.
Reduction of the metal ions may also be carried out as a separate process prior to electroless plating by preparing a catalyst activating liquid (reducing liquid), apart from the aspect of using such an electroless plating liquid as described above. The catalyst activating liquid is a liquid prepared by dissolving a reducing agent that is capable of reducing metal ions to zero-valent metal, and the concentration may be of 0.1% to 50%, and preferably 1% to 30%. For

the reducing agent, a boron-based reducing agent such as sodium borohydride or dimethylamineborane, or a reducing agent such as formaldehyde or hypophosphorous acid may be used.

The composition of a general electroless plating bath mainly contains, in addition to the solvent, (1) metal ions for plating, (2) a reducing agent, (3) an additive that enhances the stability of the metal ions (stabilizer). This plating bath may also contain, in addition to these, known additives such as a stabilizer for plating bath.

According to the invention, it is preferable to use a water-based electroless plating bath, from the viewpoint of suppressing environmental burden. Here, the water-based electroless plating bath according to the invention implies that the bath contains 50% by mass or more of water (distilled water) as a liquid component.

Examples of the metal used in the electroless plating bath that are known include copper, tin, lead, nickel, gold, palladium and rhodium, and among them, copper and gold are particularly preferred from the viewpoint of electrical conductivity.

Furthermore, there are available reducing agents and additives that are optimal for the metals mentioned above. For example, an electroless plating bath for copper contains $CuSO_4$ as a copper salt; HCOH as a reducing agent; and as additives, EDTA as a stabilizer for copper ions or a chelating agent such as Rochelle's salt, trialkanolamine and the like. A plating bath used in the electroless plating of CoNiP contains cobalt sulfate and nickel sulfate as metal salts; sodium hypophosphite as a reducing agent, sodium malonate, sodium malate and sodium succinate as complexing agents. Furthermore, an electroless plating bath for palladium contains $(Pd(NH_3)_4)Cl_2$ as a metal ion; $NH_3$ and $H_2NNH_2$ as reducing agents; and EDTA as a stabilizer. These plating baths may also contain components in addition to the above components.

The thickness of the plating film thus formed by electroless plating may be controlled by means of the metal ion concentration in the plating bath, the duration of immersion into the plating bath, temperature of the plating bath or the like, but from the viewpoint of electrical conductivity, the duration of immersion into the plating bath is preferably about 1 minute to 6 hours, and more preferably about 1 minute to 3 hours.

It was confirmed with regard to the plating film obtained by subjecting the substrate having a resin layer to electroless plating as described above, that when the plating film was cross-sectionally observed by SEM, microparticles formed from the catalytic element or the plating metal were densely dispersed in the resin layer, and furthermore, the plating metal was precipitated out onto the surface of the resin layer. Since the interface between the resin layer and the plating film adopts a structure in which the polymer and the plating film are very finely engaged with each other, even though the interface between the resin layer (organic component) and the inorganic matter (plating film) is smooth (for example, an unevenness of 500 nm or less), the adhesiveness becomes satisfactory.

(Electroplating)

According to the present step, when the catalytic element contained in the resin layer has a function as an electrode in the step (a), the resin layer may be subjected to electroplating.

Furthermore, after the electroless plating described above, electroplating may be further carried out using the formed plating film as an electrode. Thereby, an electroless plating film having excellent adhesiveness to the substrate (resin layer) is used as a base, and a new metal film having any thickness may be easily formed thereon. As such, when electroplating is carried out after electroless plating, a metal film may be formed to an intended thickness according to the purpose, and therefore, the resulting metal-clad substrate may be applied to various applications.

As the method of electroplating according to the invention, a conventionally known method may be used. Furthermore, examples of the metal used in electroplating include copper, chromium, lead, nickel, gold, silver, tin, zinc and the like, and from the viewpoint of electrical conductivity, the metal is preferably copper, gold or silver, and more preferably copper.

The thickness of the metal film obtainable by electroplating varies in accordance with the use, and the thickness may be controlled by adjusting the metal concentration contained in the plating bath, current density or the like. In addition, in the case of using the metal film in general electrical wiring or the like, the thickness is preferably 0.5 $\mu$m or greater, and more preferably 3 $\mu$m or greater, from the viewpoint of electrical conductivity.

Furthermore, as discussed above, when the steps (a) and (b) are carried out, a plating film (metal foil) is formed on the surface of the resin layer, and thus a metal-clad substrate is obtained.

The metal-clad substrate obtained by the production method described above (metal-clad substrate of the invention) is preferably in the form of the following aspect.

That is, the arithmetic average roughness Ra, as defined in JIS B 0601 (2001), of the interface of the resin layer and the plating film, which appears when the metal-clad substrate is dissected along the normal line direction, is from 5 nm to 100 nm. Furthermore, if more weight is to be put on less roughening and stronger adhesion, the arithmetic average roughness Ra is more preferably from 10 nm to 80 nm, and even more preferably from 15 nm to 60 nm.

It is also preferable that the interface structure of the resin layer and the plating film, which appears when the metal-clad substrate is dissected along the normal line direction, be in a fractal shape, and the fractal dimension of the

interface structure calculated by applying the box count method, with the box size set at 50 nm to 5 μm and the pixel size set at 1/100 of the box size or less, be from 1.05 to 1.50. From the viewpoint of manifesting strong adhesion, the fractal dimension is more preferably from 1.10 to 1.50, and even more preferably from 1.15 to 1.50.

The "arithmetic average roughness Ra" according to the invention is based on the arithmetic average roughness Ra as defined in JIS B 0601 (2001). Also, the surface roughness is evaluated according to the procedure for evaluation of the roughness as defined in JIS B 0633 (2001).

The "fractal dimension" according to the invention is defined as follows. If the number of boxes needed to cover a certain figure F with boxes (box) having a size of δ is defined as Nδ(F), the box dimension is defined by the following formula.

$$D_B = -\lim_{\delta \to 0} \frac{\log N_\delta(F)}{\log \delta}$$

Here, the box may be selected to be a sphere having a radius of δ, or may be selected to be a cube having an edge length of δ. The dimension value does not depend on the form of such a box.

In this method, there occurs a fluctuation in the calculated fractal dimension due to the difference between the box size which corresponds to the size of the field of vision and the pixel size which corresponds to resolution. However, according to the invention, the shape of the fine surface unevenness and the smoothness that does not affect the high frequency characteristics, which are needed for the surface of the resin layer, are taken into consideration, and upon determining the fractal dimension, the box size is defined to be 50 nm to 5 μm, while the size of δ (pixel size) is defined to be in the range of 1/100 of the box size or less.

In the metal-clad substrate obtained by the production method described above (metal-clad substrate of the invention), the plating film (metal foil) is excellent in the adhesiveness to the resin layer, and may be applied to various applications such as, for example, electromagnetic wave shielding films, coating films, bilayer CCL materials, and materials electrical wiring.

The plating film (metal foil) obtained by the method for producing a metal-clad substrate of the invention may be produced into a metal pattern, by etching the plating film into a pattern form.

This (c) etching step will be explained below.

[Step (c)]

In the step (c), when the plating film (metal foil) obtained by the method for producing a metal-clad substrate of the invention is etched into a pattern form, unnecessary parts of the plating film are removed, and a desired metal pattern may be obtained.

The formation of this metal pattern may use any available technique, and specifically, use is made of a subtractive method and a semi-additive method, which are generally known.

The subtractive method is a method for forming a metal pattern by providing a dry film resist layer on a plating film that has been formed, performing pattern exposure and development to form the same pattern as a metal pattern section, and removing the plating film with an etching liquid while using the dry film resist pattern as a mask. Any material may be used for the dry film resist, and any negative type, positive type, liquid or film-like materials may be used. For the etching method, any of methods that are used upon the production of printed wiring boards may be used, and wet etching, dry etching or the like may be used. The etching method may be arbitrarily selected. In view of workability of the operation, wet etching uses convenient instruments and is preferable. Examples of the etching liquid that may be used include aqueous solutions of cupric chloride, ferric chloride and the like.

The semi-additive method is a method for forming a metal pattern by providing a dry film resist layer on a plating film that has been formed, performing pattern exposure and development to form the same pattern as the non-metal pattern section, performing electroplating while using the dry film resist pattern as a mask, removing the dry film resist pattern, subsequently performing quick etching, and removing the plating film in a pattern form. The same materials as those used in the subtractive method may be used for the dry film resist, etching liquid and the like. Furthermore, the techniques described above may be used for the electroplating technique.

As the above steps (a) to (c) are carried out, a desired metal pattern may be obtained on a substrate.

On the other hand, a plating film of a desired pattern may be obtained by preliminarily forming a resin layer in a pattern form, and subjecting such a resin layer to the step (b) described above (full additive process).

In regard to the method for forming a resin layer in a pattern form, when a resin layer has been formed by using

a surface graft method, the energy that is applied upon forming the resin layer may be applied in a pattern form. Furthermore, when the areas where energy is not applied are removed by development, a pattern-shaped resin layer may be formed.

The development method is carried out by immersing the resin layer in a solvent which is capable of dissolving the material used to form the resin layer (for example, the compound having an interactable group and a polymerizable group, or the like). The immersion time is preferably 1 minute to 30 minutes.

The pattern-shaped resin layer may also be directly patterned by a known coating method such as a gravure printing method, an inkjet method or a spray coating method making use of a mask, subsequently applying energy, and then performing development.

Furthermore, in the case of forming a pattern-shaped resin layer using a coating liquid containing a plating catalyst or a precursor thereof and a resin, the pattern-shaped resin layer may be formed by directly patterning by a known coating method such as a gravure printing method, an inkjet method or a spray coating method making use of a mask, and then drying the resin layer.

The step (b) for forming a plating film on the pattern-formed resin layer is carried out in the same manner as the method described above.

The plating film (metal foil) thus obtained or the metal pattern is preferably such that the plating film has been provided on a resin layer having an unevenness of the surface of 500 nm or less (more preferably, 100 nm or less). It is also preferable that the 90° peel-off strength (JIS C 6481 (1996)) between the substrate and the plating film or metal pattern be 0.5 kN/m or greater. That is, the invention is characterized in that while the substrate surface is smooth, the adhesiveness between the substrate and the plating film or metal pattern is excellent.

The metal pattern thus obtained may be applied to various applications such as, for example, semiconductor chips, various electrical wiring boards, FPC, COF, TAB, antennas, multilayer wiring boards, and mother boards.

EXAMPLES

Hereinafter, the present invention will be explained in detail by way of Examples, but the invention is not intended to be limited to these. Unless particularly stated otherwise, the units "%" and "parts" are on a mass basis.

[Example 1]

[Production of substrate]

On a glass epoxy substrate, an epoxy-based insulating film (trade name: GX-13, manufactured by Ajinomoto Fine Techno Co., Inc.; thickness 45 μm) was adhered as an electrical insulating layer by heating and pressing with a vacuum laminator under the conditions of 100°C to 110°C at a pressure of 0.2 MPa, and thus a base material was obtained.

Subsequently, an insulative composition containing a polymerization initiator of the following composition was applied on the base material by a spin coating method to a thickness of 3 micrometers, and the base material was left to stand for one hour at 30°C to remove the solvent and was dried at 140°C for 30 minutes. Thus, a polymerization initiating layer (insulative polymerization-initiating layer) was formed.

(Insulative composition containing polymerization initiator)

20 parts by mass of a bisphenol A type epoxy resin (trade name: EPIKOTE 828, manufactured by Yuka-Shell Epoxy Co., Ltd.; epoxy equivalent 185), 45 parts by mass of a cresol novolac type epoxy resin (trade name: EPIKURON N-673, manufactured by Dainippon Ink & Chemicals, Inc.; epoxy equivalent 215), and 30 parts by mass of a phenol novolac resin (trade name: PHENOLITE, manufactured by Dainippon Ink % Chemicals, Inc.; phenolic hydroxyl group equivalent 105) were dissolved under heating in 20 parts of ethyl diglycol acetate and 20 parts of solvent naphtha, while the system was stirred. The solution was cooled to room temperature, and then 30 parts by mass of a cyclohexanone varnish of a phenoxy resin formed from the EPIKOTE 828 and bisphenol S (trade name: YL6747H30, manufactured by Yuka-Shell Epoxy Co., Ltd.; non-volatile fraction 30% by mass, weight average molecular weight 47000), 0.8 parts by mass of 2-phenyl-4,5-bis(hydroxymethyl)imidazole, 2 parts by mass of finely pulverized silica, and 0.5 parts by mass of a silicone-based defoaming agent were added to the solution obtained above. Furthermore, 10 parts of a polymerization initiating polymer P which had been synthesized by the following method, was added to the resulting mixture, and thus an insulative composition containing a polymerization initiator was obtained.

(Synthesis of polymerization initiating polymer P)

In a 300-ml three-necked flask, a solution containing 30 g of propylene glycol monomethyl ether (MFG) was

added and was heated to 75°C. A solution of 8.1 g of [2-(acryloyloxy)ethyl](4-benzoylbenzyl)dimethylammonium bromide, 9.9 g of 2-hydroxyethyl methacrylate, 13.5 g of isopropyl methacrylate, 0.43 g of dimethyl-2,2'-azobis(2-methylpropionate), and 30 g of MFG, was added dropwise to the flask over 2.5 hours. Subsequently, the reaction temperature was elevated to 80°C, and the reaction was further carried out for 2 hours. Thus, a polymer P having a polymerization initiating group was obtained.

After such a polymerization initiating layer as described above was formed, a curing treatment was carried out at 180°C for 30 minutes. Thereby, a substrate A1 was obtained. The surface unevenness (Rz) of this substrate A1 was 0.2 μm.

[Formation of resin layer]

(Synthesis of polymer A having interactable group and polymerizable group)

First, a polymer A having an interactable group and a polymerizable group was synthesized as described below.

In a 1000-ml three-necked flask, 35 g of N,N-dimethylacetamide was added and was heated to 75°C under a nitrogen gas stream. A solution of 6.60 g of 2-hydroxyethyl acrylate (commercially available product, manufactured by Tokyo Chemical Industry Co., Ltd.), 28.4 g of 2-cyanoethyl acrylate, and 0.65 g of V-601 (trade name, manufactured by Wako Pure Chemical Industries, Ltd.) in 35 g of N,N-dimethylacetamide, was added dropwise to the flask over 2.5 hours. After completion of the dropwise addition, the mixture was heated to 80°C, and was stirred for another 3 hours. Subsequently, the reaction solution was cooled to room temperature.

The above reaction solution was added with 0.29 g of di-tertiary-butylhydroquinone, 0.29 g of dibutyltin dilaurate, 18.56 g of KARENZ AOI (trade name, manufactured by Showa Denko K.K.), and 19 g of N,N-dimethylacetamide were added, and the mixture was allowed to react at 55°C for 4 hours. Subsequently, 3.6 g of methanol was added to the reaction liquid, and the mixture was further allowed to react for another 1.5 hours. After completion of the reaction, reprecipitation was performed with ethyl acetate:hexane = 1:1, and solids were taken out. Thus, 32 g of a polymer A having an interactable group and a polymerizable group (weight average molecular weight 15,000) was obtained.

(Preparation of coating solution)

10.5 parts by mass of the polymer A having an interactable group and a polymerizable group, 73.3 parts by mass of acetone, 33.9 parts by mass of methanol, and 4.8 parts by mass of N,N-dimethylacetamide were mixed and stirred, and thus a coating solution was prepared.

(Production of graft polymer)

The prepared coating solution was applied on the polymerization initiating layer of the substrate A1 by a spin coating method, to a thickness of 1 μm. The applied coating solution was dried for 30 minutes at 80°C, and then was irradiated for 660 seconds using a UV exposure unit (trade name: UVF-502S, manufactured by San-Ei Electric Co., Ltd.; lamp: UXM-501 MD) at an irradiation power of 1.5 $mW/cm^2$ (the irradiation power was measured using an ultraviolet integration actinometer (trade name: UIT150, manufactured by Ushio Denki Co., Ltd.) and a photoreceptive sensor (trade name: UVD-S254, manufactured by Ushio Denki Co., Ltd.)). Thus, a graft polymer was produced over the entire surface of the polymerization initiating layer of the substrate A1. Here, the integrated amount of exposure was 990 mJ.

Thereafter, the substrate having a graft polymer produced thereon was immersed for 5 minutes in acetone, which was being stirred. Subsequently, the substrate was washed with distilled water.

Thereby, a substrate A2 having a resin layer having a thickness of 1.0 μm was obtained.

[Application of plating catalyst]

0.05 g of palladium nitrate was added to 100 g of acetone, and the mixture was stirred for 30 minutes at room temperature. The obtained palladium nitrate dispersion liquid was passed through a 0.75-μm PTFE filter (manufactured by Advantec MFS, Inc.) to remove coarse particles of the dispersion liquid, and thus, coarse particles were removed. Thereby, a palladium nitrate solution having an average particle size of 6.8 nm was obtained. The particle size measurement was carried out with a Nanotrac particle size distribution analyzer (trade name: UPA-EX150, manufactured by Nikkiso Co., Ltd.).

The substrate A2 having a resin layer was immersed in the aforementioned palladium nitrate solution for 20 minutes, subsequently immersed in acetone for 3 minutes, and further immersed in distilled water for 3 minutes. The substrate was washed.

(Content of plating catalyst in resin layer)

In regard to the content of the plating catalyst in the resin layer, to which the plating catalyst had been applied as described above, a sample which measured 50 mm on each side was produced, and the content was measured using RBS as described above.
The measurement results are presented in Table 1.

[Electroless plating]

The substrate A2 having a resin layer to which a plating catalyst had been applied as described above, was subjected to electroless plating at 26°C for 10 minutes using an electroless plating bath having the composition shown below, which used THRU-CUP PGT (trade name, manufactured by C. Uyemura & Co., Ltd.; THRU-CUP PGT-liquid A, liquid B, liquid C). The thickness of the obtained electroless copper plating film was about 0.2 μm.

(Composition of electroless plating bath)

- Distilled water 79.2 vol%
- THRU-CUP PGT-liquid A (trade name, manufactured by C. Uyemura & Co., Ltd.) 9.0 vol%
- THRU-CUP PGT-liquid B (trade name, manufactured by C. Uyemura & Co., Ltd.) 6.0 vol%
- THRU-CUP PGT-liquid C (trade name, manufactured by C. Uyemura & Co., Ltd.) 3.5 vol%
- Formalin liquid (manufactured by Wako Pure Chemical Industries, Ltd., special grade product) 2.3 vol%

The pH of the plating bath having the above composition was adjusted to 12.6 (25°C) with sodium hydroxide and sulfuric acid.

[Electroplating]

Subsequently, electroplating was performed for 18 minutes, using the electroless copper plating film as a power supply layer and using a copper electroplating bath having the composition shown below under the conditions of 3 $A/dm^2$. The thickness of the obtained copper electroplating film was 10 μm.

(Composition of electroplating bath)

- Copper sulfate 38 g
- Sulfuric acid 95 g
- Hydrochloric acid 1 mL
- COPPER GLEAM PCM (trade name, manufactured by Meltex, Inc.) 3 mL
- Distilled water 500 g

As described above, a metal-clad substrate having a plating film formed thereon was obtained.

[Evaluation of plating film]

(Peel-off strength)

The obtained plating film was subjected to a 90° peel-off test by the method described in the test on copper-clad laminate for printed wiring boards of JIS C 6481 (1996). The testing machine used was AUTOGRAPH AGS-J (trade name) manufactured by Shimadzu Corp. The width of the copper foil to be peeled off was 10 mm, and the peel-off rate was 50 mm per minute.
The results are presented in the following Table 1.

(Measurement of surface roughness and fractal dimension)

The arithmetic average roughness Ra, as defined in JIS B 0601 (2001), and the fractal dimension of the interface

of the resin layer and the plating film, which appears when the metal-clad substrate was dissected along the normal line direction, were measured as follows.

In order to take photographs of the cross-sectional structure of the metal-clad substrate, sample processing was carried out using a dual-beam FIB apparatus (trade name: DUAL BEAM NOVA200 NANOLAB, manufactured by FEI Company; accelerating voltage 30 kV), and the cross-section of the interface of the copper plating film and the resin layer was revealed. The cross-section was observed with a focused ion beam apparatus (trade name: SMI9200, manufactured by Seiko Instruments, Inc.), and the image was obtained as bitmap data with a single-pixel size of 5 nm. The interface area (line segment) of the copper plating film and the resin layer in the cross-section photograph was extracted by image processing. The arithmetic average roughness Ra was calculated based on JIS B 0633 (1994), and the fractal dimension (box count dimension) was calculated using the box count method. The size of the region was set at 640 nm × 640 μm (128 pixels × 128 pixels), so that the structural complexity in a microscopic region could be evaluated.

The measurement results are presented in the following Table 1.

[Example 2]

A resin layer having a plating catalyst applied therein was formed in the same manner as in Example 1, except that the substrate A2 having a polymer layer used in the section [Application of plating catalyst] of Example 1 was immersed in the palladium nitrate solution mentioned above for 5 minutes, subsequently immersed in acetone for 3 minutes, further immersed in distilled water for 3 minutes, and was washed. The content of the plating catalyst in the obtained resin layer was measured in the same manner as in Example 1, and the results are presented in the following Table 1.

Furthermore, the obtained resin layer was subjected to electroless plating and electroplating in the same manner as in Example 1, and thus a metal-clad substrate having a copper plating film having a thickness of 10 μm was obtained.

The peel-off strength, arithmetic average roughness Ra and fractal dimension of the obtained metal-clad substrate were measured in the same manner as in Example 1. These results are presented in the following Table 1.

[Example 3]

A metal-clad substrate having a copper plating film having a thickness of 10 μm was obtained in the same manner as in Example 1, except that the ratio of palladium nitrate to 100 g of acetone used in the section [Application of plating catalyst] of Example 1 was changed to 0.20 g.

[Example 4]

A metal-clad substrate having a copper plating film having a thickness of 10 μm was obtained in the same manner as in Example 1, except that 0.20 g of palladium nitrate was added to 100 g of a liquid prepared by mixing water and acetone at a mass ratio of 50/50 for the procedure of the section [Application of plating catalyst] of Example 1.

[Example 5]

A metal-clad substrate having a copper plating film having a thickness of 10 μm was obtained in the same manner as in Example 1, except that 0.20 g of palladium nitrate was added to 100 g of a liquid prepared by mixing water and acetone at a mass ratio of 70/30 for the procedure of the section [Application of plating catalyst] of Example 1.

[Example 6]

A metal-clad substrate having a copper plating film having a thickness of 10 μm was obtained in the same manner as in Example 1, except that 0.05 g of benzonitrile dichloropalladium was added to 100 g of acetone for the procedure of the [Application of plating catalyst] of Example 1.

[Example 7]

A metal-clad substrate having a copper plating film having a thickness of 10 μm was obtained in the same manner as in Example 1, except that 0.05 g of palladium sulfate was added to 100 g of acetone for the procedure of the [Application of plating catalyst] of Example 1.

[Comparative Example 1]

A metal-clad substrate having a copper plating film having a thickness of 10 μm was obtained in the same manner as in Example 1, except that 1.0 g of palladium nitrate was added to 100 g of acetone for the procedure of the [Application of plating catalyst] of Example 1.

[Comparative Example 2]

The production was carried out in the same manner as in Example 1, except that 0.02 g of palladium nitrate was added to 100 g of a liquid prepared by mixing water and acetone at a mass ratio of 70/30 for the procedure of the section [Application of plating catalyst] of Example 1. However, precipitation of the plating film due to electroless plating could not be verified.

This is thought to be because, since the amount of palladium nitrate attached to the resin layer was extremely small, the plating growth rate (rate of production of plating core) was markedly slowed. Therefore, if the time for electroless plating was extended to, for example, 30 minutes or longer, a plating film is obtained, even though the plating film lacks the uniformity that is equivalent to that of Examples.

Also for Example 3 to Example 7 and Comparative Examples 1 and 2, the content of the plating catalyst in the obtained resin layer was measured in the same manner as in Example 1, at a time point where the resin layer to which the plating catalyst had been applied was formed during the production process for the metal-clad substrate.

Furthermore, the peel-off strength, arithmetic average roughness Ra and fractal dimension were also measured for the metal-clad substrates obtained in Example 3 to Example 7 and Comparative Example 1, in the same manner as in Example 1.

These measurement results are also indicated together in the following Table 1.

[Table 1]

| | Peel-off strength [N/mm] | Density of Pd element [$\times 10^{-20}$ mol/nm$^3$] | | | Arithmetic average roughness [nm] | Fractal dimension |
|---|---|---|---|---|---|---|
| | | ~ 25 nm | ~ 50 nm | ~ 100 nm | | |
| Example 1 | 0.71 | 16 | 26.5 | 44.5 | 34 | 1.14 |
| Example 2 | 0.76 | 10.5 | 17 | 31 | 75 | 1.18 |
| Example 3 | 0.70 | 24 | 44.5 | 77 | 14 | 1.06 |
| Example 4 | 0.68 | 22 | 37 | 53 | 17 | 1.07 |
| Example 5 | 0.76 | 19.5 | 33.5 | 47.5 | 24 | 1.08 |
| Example 6 | 0.73 | 13.5 | 24 | 39 | 44 | 1.14 |
| Example 7 | 0.66 | 16 | 27.5 | 47 | 31 | 1.08 |
| Comparative Example 1 | 0.15 | 43.5 | 78 | 135 | Less than 5 | 1.01 |
| Comparative Example 2 | - | 2.5 | 4.5 | 9 | - | - |

As is obvious from the Table 1, it was found that the peel-off strengths of the metal-clad substrates obtained in the Examples were very high as compared with the peel-off strength of Comparative Example 1.

It was also found that in Comparative Example 1, the content of the plating catalyst in the resin layer was too large, and thus the arithmetic average roughness Ra decreased, while the peel-off strength was markedly lowered.

## Claims

1. A metal-clad substrate comprising, on a substrate, a resin layer containing a plating catalyst or a precursor thereof and a copolymer having a polymerizable group and a functional group which is capable of forming interaction with

the plating catalyst or a precursor thereof, **characterized in that** the copolymer contains a unit represented by the following formula (1) and a unit represented by the following formula (2):

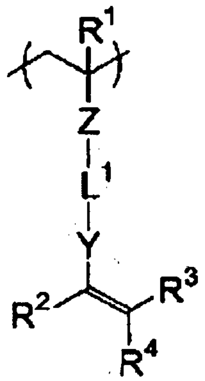

Formula (1)

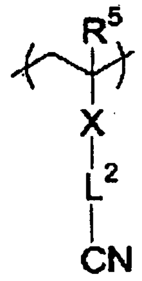

Formula (2)

wherein in formula (1) and formula (2), $R^1$ to $R^5$ each independently represent a hydrogen atom, or a substituted or unsubstituted alkyl group; X, Y and Z each independently represent a single bond, a substituted divalent organic group, an unsubstituted divalent organic group, an ester group, an amide group, or an ether group; and $L^1$ and $L^2$ each independently represent a substituted or unsubstituted divalent organic group;
and the resin layer satisfies the following requirement 1, and a plating film formed inside and on top of the resin layer:

Requirement 1: the resin layer contains the plating catalyst or a precursor thereof within a portion extending from a surface to a depth of 25 nm of the resin layer, in an amount in the range of 3 x $10^{-20}$ mol/nm$^3$ to 30 x $10^{-20}$ mol/nm$^3$ in terms of a content of a metal element thereof.

2. The metal-clad substrate of claim 1, wherein an arithmetic average roughness Ra, as defined in JIS B 0601 (2001), of an interface of the resin layer and the plating film, which appears when the metal-clad substrate is dissected along a normal line direction, is from 5 nm to 100 nm.

3. A metal-clad substrate of claim 1 or claim 2, in which an interface structure of a resin layer and a plating film, which appears when the metal-clad substrate is dissected along a normal line direction, is in a fractal form, and in which a fractal dimension of the interface structure calculated by applying the box count method, with a box size set at 50 nm to 5 $\mu$m and a pixel size set at 1/100 or less of the box size, is from 1.05 to 1.50.

4. The metal-clad substrate of any one of claims 1 to 3, wherein the metal element of the plating catalyst or a precursor thereof is selected from the group consisting of Pd, Ag, Cu, Cr, Pt, Rh, Sn and Ni.

5. A method for producing a metal-clad substrate, the method comprising:

(a) forming, on a substrate, a resin layer containing a plating catalyst or a precursor thereof and a copolymer having a polymerizable group and a functional group which is capable of forming interaction with the plating catalyst or a precursor thereof, wherein the copolymer contains a unit represented by the following formula (1) and a unit represented by the following formula (2):

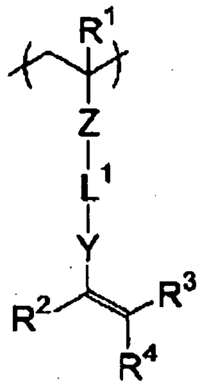

Formula (1)

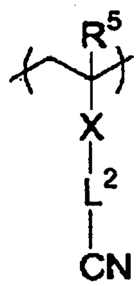

Formula (2)

wherein in formula (1) and formula (2), $R^1$ to $R^5$ each independently represent a hydrogen atom, or a substituted or unsubstituted alkyl group; X, Y and Z each independently represent a single bond, a substituted divalent organic group, an unsubstituted divalent organic group, an ester group, an amide group, or an ether group; and $L^1$ and $L^2$ each independently represent a substituted or unsubstituted divalent organic group;
and the resin layer satisfies the following requirement 1; and
(b) performing plating on the resin layer:

Requirement 1: the resin layer contains the plating catalyst or a precursor thereof within a portion extending from a surface to a depth of 25 nm of the resin layer, in an amount in the range of 3 x $10^{-20}$ mol/$nm^3$ to 3.0 x $10^{-20}$ mol/$nm^3$ in terms of a content of a metal element thereof.

**6.** The method for producing a metal-clad substrate of claim 5, wherein the metal element of the plating catalyst or a precursor thereof is selected from the group consisting of Pd, Ag, Cu, Cr, Pt, Rh, Sn and Ni.

**Patentansprüche**

**1.** Metallausgekleidetes Substrat, das auf einem Substrat folgendes umfasst: eine Harzschicht, die einen Beschichtungskatalysator oder einen Vorläufer davon und ein Copolymer umfasst, das eine polymerisierbare Gruppe und eine funktionelle Gruppe hat, die mit dem Beschichtungskatalysator oder einem Vorläufer davon in Wechselwirkung treten kann, **dadurch gekennzeichnet, dass** das Copolymer eine Einheit enthält, die durch die folgende Formel (1) beschrieben wird, sowie eine Einheit, die durch die folgende Formel (2) beschrieben wird

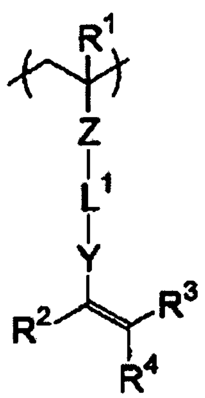

Formel (1)

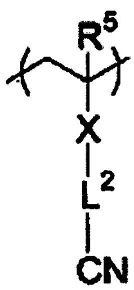

Formel (2)

wobei in der Formel (1) und der Formel (2) $R^1$ bis $R^5$ jeweils unabhängig voneinander ein Wasserstoffatom oder

eine substituierte oder unsubstituierte Alkylgruppe sind; X, Y und Z jeweils unabhängig voneinander eine Einfachbindung, eine substituierte bivalente organische Gruppe, eine unsubstituierte bivalente organische Gruppe, eine Estergruppe, eine Amidgruppe oder eine Ethergruppe sind; und $L^1$ und $L^2$ jeweils unabhängig voneinander eine substituierte oder unsubstituierte bivalente organische Gruppe sind;
und die Harzschicht die folgende Bedingung 1 erfüllt, und ein Beschichtungsfilm innerhalb und auf der Harzschicht gebildet ist:

Bedingung 1: die Harzschicht umfasst den Beschichtungskatalysator oder einen Vorläufer davon, in einem Bereich, der sich von einer Oberfläche bis in eine Tiefe von 25 nm der Harzschicht erstreckt, in einer Menge im Bereich von 3 x $10^{-20}$ mol/$nm^3$ bis 30 x $10^{-20}$ mol/$nm^3$, bezogen auf deren Gehalt an Metallelement.

**2.** Metallausgekleidetes Substrat nach Anspruch 1, in dem der arithmetische Mittelrauigkeitswert Ra, wie in JIS B 0601 (2001) definiert, der Grenzfläche der Harzschicht und des Beschichtungsfilms, die sichtbar wird, wenn das metallausgekleidete Substrat entlang einer Normallinienrichtung geschnitten wird, von 5 nm bis 100 nm ist.

**3.** Metallausgekleidetes Substrat nach Anspruch 1 oder Anspruch 2, in dem eine Grenzflächenstruktur der Harzschicht und des Beschichtungsfilms, die sichtbar wird, wenn das metallausgekleidete Substrat entlang einer Normallinienrichtung geschnitten wird, in einer fraktalen Form ist, und eine fraktale Dimension der Grenzflächenstruktur, die mittels einer Methode berechnet wird, bei der Zellen gezählt werden (Boxcounting-Methode), wobei die Kantenlänge der Zellen auf 50 nm bis 5 $\mu$m gesetzt wird und die Pixelgröße auf 1/100 der Kantenlänge oder weniger gesetzt wird, 1,05 bis 1,50 ist.

**4.** Metallausgekleidetes Substrat nach mindestens einem der Ansprüche 1 bis 3, in dem das Metallelement des Beschichtungskatalysators oder eines Vorläufers davon aus der Gruppe ausgewählt ist, die aus Pd, Ag, Cu, Cr, Pt, Rh, Sn und Ni besteht.

**5.** Verfahren zur Herstellung eines metallausgekleideten Substrats, wobei das Verfahren umfasst:

(a) Bilden einer Harzschicht auf einem Substrat, die einen Beschichtungskatalysator oder einen Vorläufer davon und ein Copolymer umfasst, das eine polymerisierbare Gruppe und eine funktionelle Gruppe hat, die mit dem Beschichtungskatalysator oder einem Vorläufer davon in Wechselwirkung treten kann, wobei das Copolymer eine Einheit enthält, die durch die folgende Formel (1) beschrieben wird, sowie eine Einheit, die durch die folgende Formel (2) beschrieben wird:

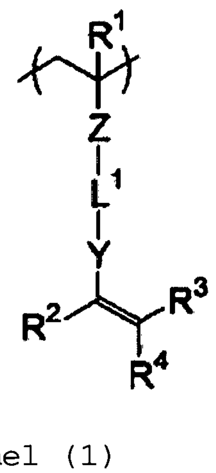

Formel (1)

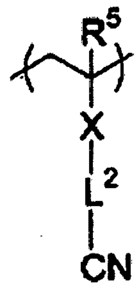

Formel (2)

wobei in der Formel (1) und der Formel (2) $R^1$ bis $R^5$ jeweils unabhängig voneinander ein Wasserstoffatom oder eine substituierte oder unsubstituierte Alkylgruppe sind; X, Y und Z jeweils unabhängig voneinander eine Einfachbindung, eine substituierte bivalente organische Gruppe, eine unsubstituierte bivalente organische Gruppe, eine Estergruppe, eine Amidgruppe oder eine Ethergruppe sind; und $L^1$ und $L^2$ jeweils unabhängig voneinander eine substituierte oder unsubstituierte bivalente organische Gruppe sind;
und die Harzschicht die folgende Bedingung 1 erfüllt; und
(b) Beschichten der Harzschicht:

Bedingung 1: die Harzschicht umfasst den Beschichtungskatalysator oder einen Vorläufer davon, in einem Bereich, der sich von einer Oberfläche bis in eine Tiefe von 25 nm der Harzschicht erstreckt, in einer Menge im Bereich von 3 x $10^{-20}$ mol/$nm^3$ bis 30 x $10^{-20}$ mol/$nm^3$, bezogen auf deren Gehalt an Metallelement.

**6.** Verfahren zur Herstellung eines metallausgekleideten Substrats nach Anspruch 5, bei dem das Metallelement des Beschichtungskatalysator oder eines Vorläufers davon aus der Gruppe ausgewählt ist, die aus Pd, Ag, Cu, Cr, Pt, Rh, Sn und Ni besteht.

## Revendications

**1.** Substrat à placage métallique comprenant, sur un substrat, une couche de résine contenant un catalyseur de placage ou un précurseur de celui-ci et un copolymère ayant un groupe polymérisable et un groupe fonctionnel qui est apte à former une interaction avec le catalyseur de placage ou un précurseur de celui-ci, **caractérisé en ce que** le copolymère contient une unité représentée par la formule (1) suivante et une unité représentée par la formule (2) suivante :

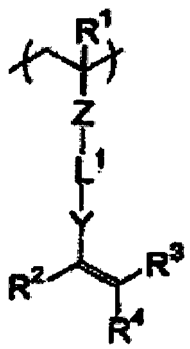

Formule (1)

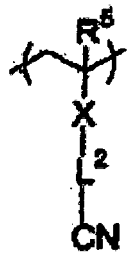

Formule (2)

dans lequel, dans la formule (1) et la formule (2), $R^1$ à $R^5$ représentent chacun indépendamment un atome d'hydrogène, ou un groupe alkyle substitué ou non substitué ; X, Y et Z représentent chacun indépendamment une liaison simple, un groupe organique divalent substitué, un groupe organique divalent non substitué, un groupe ester, un groupe amide, ou un groupe éther ; et $L^1$ et $L^2$ représentent chacun indépendamment un groupe organique divalent substitué ou non substitué ;
et la couche de résine satisfait à l'exigence 1 suivante, et un film de placage formé à l'intérieur et pardessus la couche de résine :

Exigence 1 : la couche de résine contient le catalyseur de placage ou un précurseur de celui-ci à l'intérieur d'une partie s'étendant d'une surface jusqu'à une profondeur de 25 nm de la couche de résine, dans une quantité dans la plage de 3 x $10^{-20}$ mole/$nm^3$ à 30 x $10^{-20}$ mole/$nm^3$ en termes d'une teneur d'un élément métal de celui-ci.

**2.** Substrat à placage métallique selon la revendication 1, dans lequel une rugosité moyenne arithmétique Ra, telle que définie dans JIS B 0601 (2001), d'une interface de la couche de résine et du film de placage, qui apparaît lorsque le substrat à placage métallique est découpé dans le sens d'une ligne normale, est de 5 nm à 100 nm.

**3.** Substrat à placage métallique selon la revendication 1 ou la revendication 2, dans lequel une structure d'interface d'une couche de résine et d'un film de placage, qui apparaît lorsque le substrat à placage métallique est découpé dans le sens d'une ligne normale, est sous une forme fractale, et dans lequel une dimension fractale de la structure d'interface calculée en appliquant le procédé de compte de cubes de recouvrement, avec une taille de cubes fixée à 50 nm à 5 $\mu$m et une taille de pixels fixée à 1/100 ou moins de la taille de cubes, est de 1,05 à 1,50.

**4.** Substrat à placage métallique selon l'une quelconque des revendications 1 à 3, dans lequel l'élément métal du catalyseur de placage ou d'un précurseur de celui-ci est choisi parmi le groupe consistant en Pd, Ag, Cu, Cr, Pt, Rh, Sn et Ni.

**5.** Procédé de production d'un substrat à placage métallique, le procédé comprenant :

(a) la formation, sur un substrat, d'une couche de résine contenant un catalyseur de placage ou un précurseur de celui-ci et un copolymère ayant un groupe polymérisable et un groupe fonctionnel qui est apte à former une interaction avec le catalyseur de placage ou un précurseur de celui-ci, dans lequel le copolymère contient une unité représentée par la formule (1) suivante et une unité représentée par la formule (2) suivante :

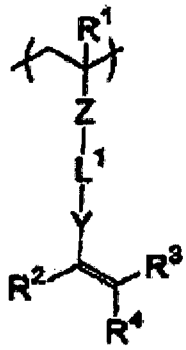

Formule (1)

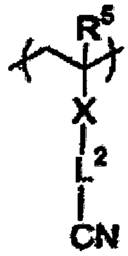

Formule (2)

dans lequel, dans la formule (1) et la formule (2), $R^1$ à $R^5$ représentent chacun indépendamment un atome d'hydrogène, ou un groupe alkyle substitué ou non substitué ; X, Y et Z représentent chacun indépendamment une liaison simple, un groupe organique divalent substitué, un groupe organique divalent non substitué, un groupe ester, un groupe amide, ou un groupe éther ; et $L^1$ et $L^2$ représentent chacun indépendamment un groupe organique divalent substitué ou non substitué ;
et la couche de résine satisfait à l'exigence 1 suivante ; et
(b) l'exécution d'un placage sur la couche de résine :

Exigence 1 : la couche de résine contient le catalyseur de placage ou un précurseur de celui-ci à l'intérieur d'une partie s'étendant d'une surface jusqu'à une profondeur de 25 nm de la couche de résine, dans une quantité dans la plage de $3 \times 10^{-20}$ mole/nm$^3$ à $30 \times 10^{-20}$ mole/nm$^3$ en termes d'une teneur d'un élément métal de celui-ci.

**6.** Procédé de production d'un substrat à placage métallique selon la revendication 5, dans lequel l'élément métal du catalyseur de placage ou d'un précurseur de celui-ci est choisi parmi le groupe consistant en Pd, Ag, Cu, Cr, Pt, Rh, Sn et Ni.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 8316612 A
- JP 2006193780 A
- JP 2006135271 A
- JP 63092658 A
- JP 10296895 A
- JP 11119413 A
- JP 2005281350 A
- JP 2007154306 A
- JP 2005307140 A


### Non-patent literature cited in the description


- New Polymer Experimentology. Kyoritsu Shuppan co., Ltd, 1994, vol. 10, 135
- Handbook of Adsorption Technology. NTS, Inc, February 1999, 203-695
- *Proceedings for the 18th Symposium of Japan Institute of Electronics Packaging,* 2004, 189
- **OKITSU, TOSHINAO.** *Journal of the Adhesion Society of Japan,* 1993, vol. 29 (3